# EUROPEAN PATENT APPLICATION

(11) **EP 4 842 159 A1**
(43) Date of publication of application: **18.11.2026**
(21) Application number: 26165765.4
(22) Date of filing: 18.03.2026
(51) Int. Cl.: H10D 30/01, H10D 30/00, H10D 62/10, H10D 62/17, H10D 64/23

(54) **SEMICONDUCTOR DEVICE INCLUDING A LOWER SPACER LAYER**

(30) Priority: 14.05.2025 KR 20250062363
(71) Applicant: Samsung Electronics Co., Ltd., Suwon-si, Gyeonggi-do 16677 (KR)
(72) Inventor: YU, Hyunkwan, 16677 Suwon-si, Gyeonggi-do (KR); JUNG, Yeondo, 16677 Suwon-si, Gyeonggi-do (KR); SHIN, Dongsuk, 16677 Suwon-si, Gyeonggi-do (KR); PARK, Gwirim, 16677 Suwon-si, Gyeonggi-do (KR); KIM, Kichul, 16677 Suwon-si, Gyeonggi-do (KR)
(74) Representative: Kuhnen & Wacker Patent- und Rechtsanwaltsbüro PartG mbB

(57) **Abstract**

A semiconductor device (1000) includes an active region extending in a first horizontal direction (X); channel layers (140) apart from each other in a vertical direction (Z), on the active region; a gate structure (160) intersecting the active region and on one or more of the channel layers (140); a source/drain epitaxial layer (150) on the active region and in contact with one or more of the channel layers (140); and a lower spacer layer, wherein the gate structure (160) includes a gate electrode layer on one or more of the channel layers (140) in a second horizontal direction (Y); and a gate dielectric layer between the gate electrode layer and the channel layers (140), and between the gate electrode layer and the source/drain epitaxial layer (150), wherein the lower spacer layer includes a first portion between the gate dielectric layer and the source/drain epitaxial layer (150); and a second portion between the active region and the source/drain epitaxial layer (150).

## Description

### BACKGROUND

### 1. Field

One or more embodiments of the present disclosure may relate to a semiconductor device and/or a method of manufacturing the same.

### 2. Related Art

As demand for high performance, high speed, and/or multifunctionality of semiconductor devices has increased, the integration density of semiconductor devices has increased. To maintain the current trajectory of increasing integration density of semiconductor devices, it may be necessary to implement patterns having a fine width and/or a fine gap. Also, to overcome the limitations resulting from the reduction in size of planar metal oxide semiconductor field-effect transistors (MOSFETs), an effort has been made to develop a semiconductor device including a transistor having a three-dimensional channel structure.

### SUMMARY

One or more embodiments of the present disclosure may provide a semiconductor device having improved reliability.

One or more embodiments of the present disclosure may provide a semiconductor device, including an active region extending in a first horizontal direction; a plurality of channel layers apart from each other in a vertical direction perpendicular to the first horizontal direction on the active region; a gate structure intersecting the active region and the plurality of channel layers and on one or more of the plurality of channel layers; a source/drain epitaxial layer on the active region and in contact with one or more of the plurality of channel layers; and a lower spacer layer, wherein the gate structure includes a gate electrode layer on one or more of the plurality of channel layers in a second horizontal direction perpendicular to the vertical direction and the first horizontal direction; and a gate dielectric layer between the gate electrode layer and the plurality of channel layers, and between the gate electrode layer and the source/drain epitaxial layer, wherein the lower spacer layer includes a first portion between the gate dielectric layer and the source/drain epitaxial layer; and a second portion between the active region and the source/drain epitaxial layer.

One or more embodiments of the present disclosure may provide a semiconductor device including a first N-channel metal-oxide-semiconductor field-effect transistor (NMOS transistor) structure and a second NMOS transistor structure, wherein the first NMOS transistor structure includes a first NMOS source/drain epitaxial layer; first NMOS channel layers stacked and apart from each other in a vertical direction, and connected to the first NMOS source/drain epitaxial layer in a first horizontal direction perpendicular to the vertical direction; first NMOS gate electrode layer on the first NMOS channel layers, respectively, in a second horizontal direction perpendicular to the first horizontal direction and the vertical direction; a first NMOS gate dielectric layer between the first NMOS gate electrode layer and the first NMOS channel layers, and between the first NMOS gate electrode layer and the first NMOS source/drain epitaxial layer; and a first NMOS lower spacer layer below the first NMOS source/drain epitaxial layer, wherein the second NMOS transistor structure includes a second NMOS source/drain epitaxial layer; second NMOS channel layers stacked and apart from each other in the vertical direction, and connected to the second NMOS source/drain epitaxial layer in the first horizontal direction; a second NMOS gate electrode layer extending in the second horizontal direction and on the second NMOS channel layers, respectively, in the second horizontal direction; a second NMOS gate dielectric layer between the second NMOS gate electrode layer and the second NMOS channel layers, and between the second NMOS gate electrode layer and the second NMOS source/drain epitaxial layer; and a second NMOS lower spacer layer below the second NMOS source/drain epitaxial layer, wherein a width in the first horizontal direction at a first level of a second NMOS channel layer of the second NMOS channel layers is greater than a width in the first horizontal direction at the first level of a first NMOS channel layer of the first NMOS channel layers, wherein a level of an upper end of the first NMOS lower spacer layer is higher than a level of a lower surface of the first NMOS gate electrode layer, and wherein a level of an upper end of the second NMOS lower spacer layer is lower than a level of a lower surface of the second NMOS gate electrode layer.

One or more embodiments of the present disclosure may provide a semiconductor device, including a first NMOS transistor structure, a second NMOS transistor structure, and a third NMOS transistor structure, wherein the first NMOS transistor structure includes a first NMOS source/drain epitaxial layer; first NMOS channel layers stacked and apart from each other in a vertical direction, and connected to the first NMOS source/drain epitaxial layer in a first horizontal direction perpendicular to the vertical direction; a first NMOS gate electrode layer on the first NMOS channel layers, respectively, in a second horizontal direction perpendicular to the first horizontal direction and the vertical direction; a first NMOS gate dielectric layer between the first NMOS gate electrode layer and the first NMOS channel layers, and between the first NMOS gate electrode layer and the first NMOS source/drain epitaxial layer; and a first NMOS lower spacer layer below the first NMOS source/drain epitaxial layer, wherein the second NMOS transistor structure includes a second NMOS source/drain epitaxial layer; second NMOS channel layers stacked and apart from each other in the vertical direction, and connected to the second NMOS source/drain epitaxial layer in the first horizontal direction; a second NMOS gate electrode layer extending in the second horizontal direction and on one or more of the second NMOS channel layers in the second horizontal direction; a second NMOS gate dielectric layer between the second NMOS gate electrode layer and the second NMOS channel layers, and between the second NMOS gate electrode layer and the second NMOS source/drain epitaxial layer; and a second NMOS lower spacer layer below the second NMOS source/drain epitaxial layer, wherein the third NMOS transistor structure includes a third NMOS source/drain epitaxial layer; third NMOS channel layers stacked and apart from each other in the vertical direction, and connected to the third NMOS source/drain epitaxial layer in the first horizontal direction; a third NMOS gate electrode layer extending in the second horizontal direction and on one or more of the third NMOS channel layers in the second horizontal direction; a third NMOS gate dielectric layer between the third NMOS gate electrode layer and the third NMOS channel layers, and between the third NMOS gate electrode layer and the third NMOS source/drain epitaxial layer; and a third NMOS lower spacer layer below the third NMOS source/drain epitaxial layer, wherein a maximum width in the first horizontal direction of the second NMOS source/drain epitaxial layer is greater than a maximum width in the first horizontal direction of the first NMOS source/drain epitaxial layer, wherein a maximum width in the first horizontal direction of the third NMOS source/drain epitaxial layer is greater than a maximum width in the first horizontal direction of the second NMOS source/drain epitaxial layer, wherein a maximum width in the vertical direction of the second NMOS lower spacer layer is less than a maximum width in the vertical direction of the first NMOS lower spacer layer, and wherein a maximum width in the vertical direction of the third NMOS lower spacer layer is less than a maximum width in the vertical direction of the second NMOS lower spacer layer..

### BRIEF DESCRIPTION OF DRAWINGS

The above and other aspects, features, and advantages of the present disclosure will be more clearly understood from the following detailed description, taken in combination with the accompanying drawings, in which:
FIG. 1 is a plan diagram illustrating a semiconductor device according to one or more embodiments of the present disclosure;
FIG. 2A is a cross-sectional diagram illustrating a semiconductor device taken along lines la-la', Ib-Ib', and Ic-Ic';
FIG. 2B is an enlarged diagram illustrating region "A" in FIG. 2A;
FIG. 2C is an enlarged diagram including a concentration of impurities distributed in region "B" illustrated in FIG. 2A;
FIG. 3A is a cross-sectional diagram illustrating a semiconductor device taken along lines IIa-IIa', IIb-IIb', and IIc-IIc';
FIG. 3B is an enlarged diagram illustrating region "A" illustrated in FIG. 3A;
FIG. 4A is a cross-sectional diagram illustrating a semiconductor device taken along lines IIIa-IIIa', IIIb-IIIb', and IIIc-IIIc';
FIG. 4B is an enlarged diagram illustrating region "A" illustrated in FIG. 4A;
FIG. 5 is a cross-sectional diagram and an enlarged diagram illustrating a semiconductor device taken along line la-la' according to one or more embodiments of the present disclosure;
FIG. 6 is a cross-sectional diagram and an enlarged diagram illustrating a semiconductor device taken along line la-la' according to one or more embodiments of the present disclosure;
FIG. 7A is a cross-sectional diagram illustrating a semiconductor device taken along lines la-la', Ib-Ib', and Ic-Ic' according to one or more embodiments of the present disclosure;
FIG. 7B is an enlarged diagram illustrating region "A" illustrated in FIG. 7A; and
FIGS. 8A, 8B, 8C, 8D, 8E, 8F, 8G, 8H, 8I, and 8J are cross-sectional diagrams illustrating a method of manufacturing a semiconductor device according to one or more embodiments of the present disclosure.

### DETAILED DESCRIPTION

Hereinafter, embodiments of the present disclosure will be described as follows with reference to the accompanying drawings.

All of the embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure.

It will be understood that when an element, component, layer, pattern, structure, region, or so on (hereinafter collectively "element") of a semiconductor device is referred to as being "over," "above," "on," "below," "under," "beneath," "connected to" or "coupled to" another element of the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present.

As used herein, the term "and/or" includes any and all combinations of one or more of the associated listed items. As used herein, expressions such as "at least one of," when preceding a list of elements, modify the entire list of elements and do not modify the individual elements of the list. For example, the expression, "at least one of a, b and c," and "at least one of a, b, or c" should be understood as including only a, only b, only c, both a and b, both a and c, both b and c, or all of a, b and c.

It will be also understood that, even if a certain step or operation of manufacturing an apparatus or structure is described later than another step or operation, the step or operation may be performed later than the other step or operation unless the other step or operation is described as being performed after the step or operation.

Various embodiments of the present document and terms used therein are not intended to limit the technical features described in this document to specific embodiments, and should be understood to include various modifications, equivalents, or substitutes of the corresponding embodiments.

In connection with the description of the drawings, similar reference numerals may be used for similar or related components.

The singular form of a noun corresponding to an item may include one or a plurality of the items unless clearly indicated otherwise in a related context.

In addition, the terms "portion", "part", "unit", "module" or "member" may be implemented in hardware or software. Depending on the embodiments, a plurality of "portions", "parts", "units", "modules" or "members" may be implemented as a single element, or a single "portion", "part", "unit", "module" or "member" may include a plurality of elements.

It will be understood that, although the terms "first", "second", "third", "primary", "secondary", "tertiary", etc., may be used herein to describe various elements, but elements are not limited by these terms. These terms are only used to distinguish one element from another element. For example, without departing from the scope of the disclosure, a first element may be termed as a second element, and a second element may be termed as a first element. The term of "and/or" includes a plurality of combinations of relevant items or any one item among a plurality of relevant items.

When an element (e.g., a first element) is referred to as being "(functionally or communicatively) coupled" or "connected" to another element (e.g., a second element), the first element may be connected to the second element, directly (e.g., wired), wirelessly, or through a third element.

In this disclosure, the terms "containing", "including", "comprising", "having", and the like are used to specify features, numbers, steps, operations, elements, components, or combinations thereof, but do not preclude the presence or addition of one or more of the features, numbers, steps, operations, elements, components, or combinations thereof.

In addition, in the present disclosure, the meaning of "identical" includes cases where properties are similar to each other or similar within a certain range. Furthermore, unless clearly indicated, stated, and/or shown otherwise; as used herein the terms "identical", "uniform", "equal", and/or "the same" mean "substantially identical", "substantially uniform", "substantially equal", and/or "substantially the same". The meaning of substantially identical should be understood to include numerical values within manufacturing error ranges, machining or processing tolerances, and/or differences within a range that is so insignificant such that neither the structure nor function of the embodiments disclosed herein are materially altered, inhibited, or destroyed.

As used herein, the terms "front (or forward)", "rear (or back, rearward)", "left", "right", "up (or top)", "down (or bottom)" and the like may be defined with reference to the drawings, and may not be intended to limit the shape and position of each component.

In one or more embodiments, "NMOS transistor" may indicate an N-channel MOSFET (N-channel metal-oxide-semiconductor field-effect transistor), and "PMOS transistor" may indicate a P-channel MOSFET (P-channel metal-oxide-semiconductor field-effect transistor).

In one or more embodiments, to clearly describe elements of the NMOS transistor and elements of the PMOS transistor, a gate, a channel layer, and a source/drain, which are elements of the "NMOS transistor," may be referred to as a NMOS gate, a NMOS channel layer, and a NMOS source/drain, respectively, and a gate, a channel layer, and a source/drain, which are elements of the "PMOS transistor," may be referred to as a PMOS gate, a PMOS channel layer, and a PMOS source/drain, respectively.

In one or more embodiments, "transistor structure" may indicate a structure including a "transistor."

In one or more embodiments, to distinguish between elements of the "first NMOS transistor structure," elements of the "second NMOS transistor structure," elements of the "first PMOS transistor structure," and elements of the "first PMOS transistor structure," the elements of the "first NMOS transistor structure" will be referred to as first NMOS elements, the elements of the "second NMOS transistor structure" will be referred to as the second NMOS elements, the elements of the "first PMOS transistor structure"will be referred to as the first PMOS elements, and the elements of the "second PMOS transistor structure" will be referred to as the second PMOS elements.

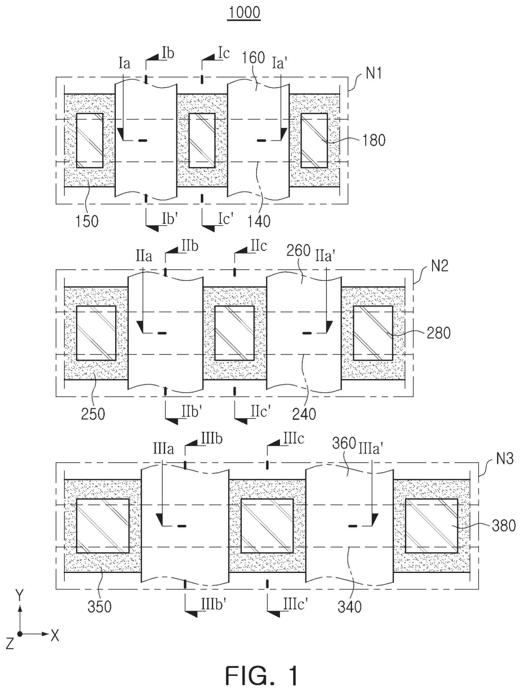

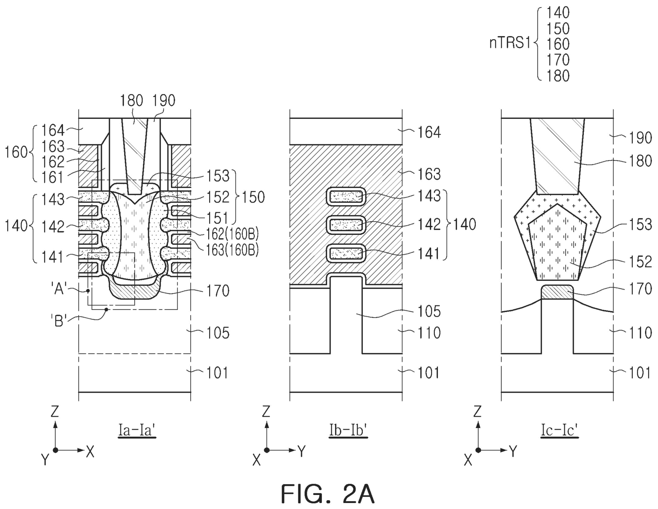

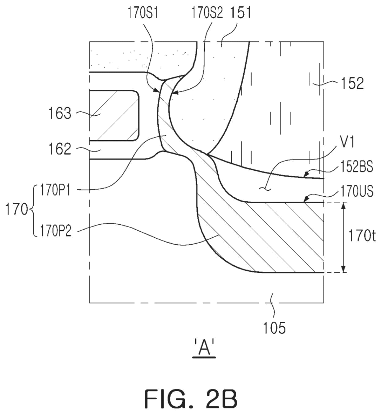

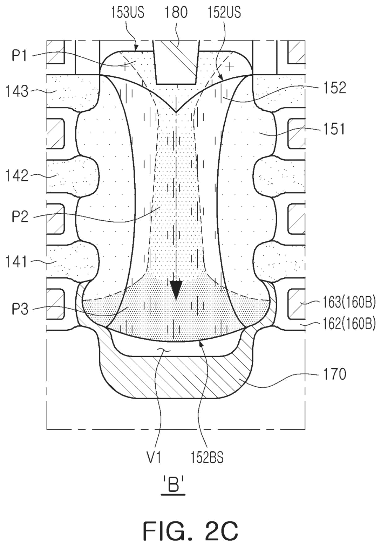

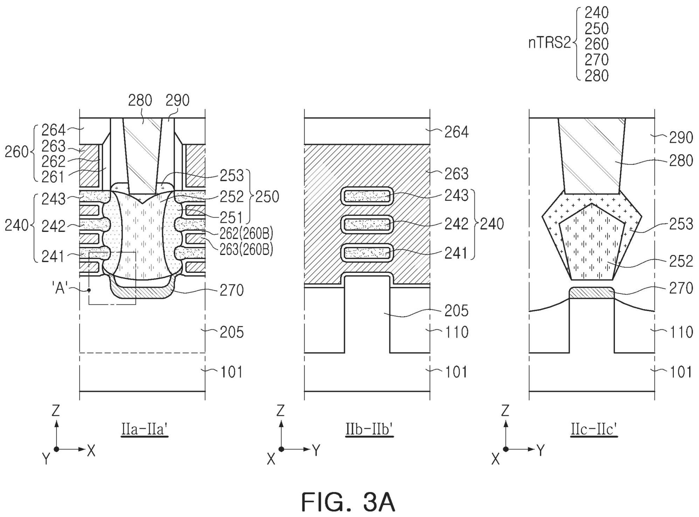

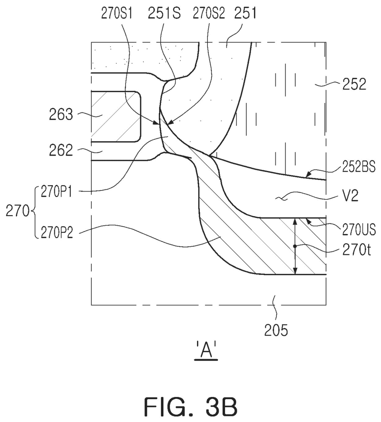

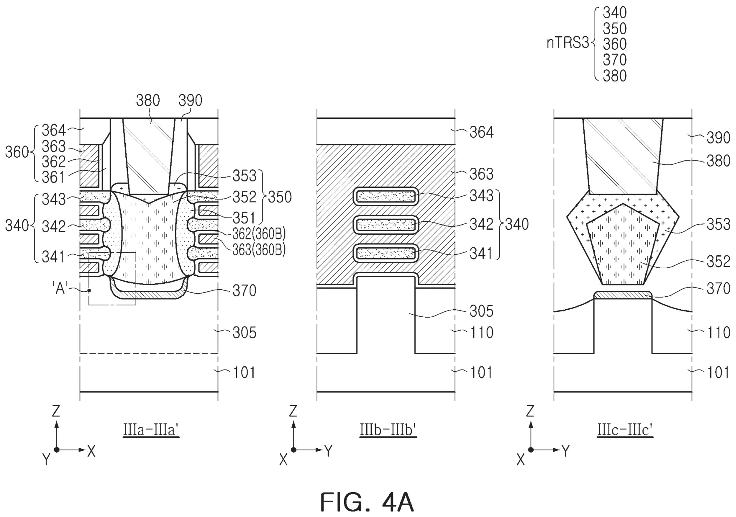

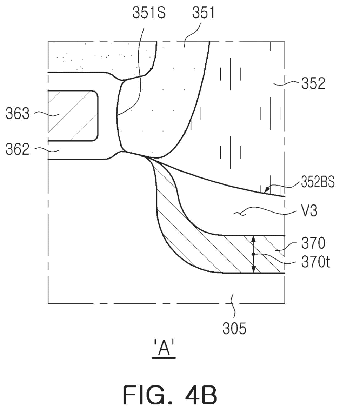

FIG. 1 is a plan diagram illustrating a semiconductor device according to one or more embodiments. FIG. 2A is a cross-sectional diagram illustrating a semiconductor device taken along lines la-la', Ib-Ib', and Ic-Ic'. FIG. 2B is an enlarged diagram illustrating region "A" in FIG. 2A. FIG. 2C is an enlarged diagram including a concentration of impurities distributed in region "B" illustrated in FIG. 2A. FIG. 3A is a cross-sectional diagram illustrating a semiconductor device taken along lines IIa-IIa', Ilb-IIb', and IIc-IIc'. FIG. 3B is an enlarged diagram illustrating region "A" illustrated in FIG. 3A. FIG. 4A is a cross-sectional diagram illustrating a semiconductor device taken along lines Illa-Illa', Illb-Illb', and IIIc-Illc'. FIG. 4B is an enlarged diagram illustrating region "A" illustrated in FIG. 4A.

The semiconductor device 1000 may comprise a first NMOS transistor region N1, a second NMOS transistor region N2, and a third NMOS transistor region N3.

The first NMOS transistor region N1, the second NMOS transistor region N2, and the third NMOS transistor region N3 may further comprise a substrate 101, active regions 105, 205, and 305 on the substrate 101, and a device isolation layer 110 disposed on side surfaces of the active regions 105, 205, and 305 on the substrate 101.

The first NMOS transistor region N1 may comprise a first NMOS transistor structure nTRS1, the second NMOS transistor region N2 may comprise a second NMOS transistor structure nTRS2, and the third NMOS transistor region N3 may comprise a third NMOS transistor structure nTRS3.

The first NMOS transistor region N1 may comprise the first active region 105 among the active regions 105, 205, and 305, the second NMOS transistor region N2 may comprise the second active region 205 among the active regions 105, 205, and 305, and the third NMOS transistor region N3 may comprise the third active region 305 among the active regions 105, 205, and 305.

The second NMOS transistor structure nTRS2 may comprise a second NMOS channel structure 240 having a longer length in the first horizontal direction X than the first NMOS channel structure 140 of the first NMOS transistor structure nTRS1, and the third NMOS transistor structure nTRS3 may comprise a third NMOS channel structure 340 having a longer length in the first horizontal direction X than the second NMOS channel structure 240 of the second NMOS transistor structure nTRS2. Also, the second NMOS source/drain epitaxial layer 250 of the second NMOS transistor structure nTRS2 may be formed to have a greater width in the first horizontal direction X than the first NMOS source/drain epitaxial layer 150 of the first NMOS transistor structure nTRS1, and the third NMOS source/drain epitaxial layer 350 of the third NMOS transistor structure nTRS3 may have a greater width in the first horizontal direction X than the second NMOS source/drain epitaxial layer 250 of the second NMOS transistor structure nTRS2.

The length in the first horizontal direction X of the channel and the width in the first horizontal direction X of the source/drain epitaxial layer may be proportional to each other, and may be independently configured depending on design conditions and the purpose of the device. By such structural differentiation, an optimized device configuration may be implemented according to electrical properties and operating conditions required by each of the NMOS transistor regions N1, N2, and N3.

The substrate 101 may have an upper surface extending in the first horizontal direction X and the second horizontal direction Y. The substrate 101 may comprise a semiconductor material, for example, a group IV semiconductor, a group III-V compound semiconductor, or a group II-VI compound semiconductor. For example, the group IV semiconductor may comprise silicon, germanium, or silicon-germanium. The substrate 101 may be provided as a bulk (i.e., monolithic, single-crystal) wafer, an epitaxial layer, a silicon on insulator (SOI) layer, or a semiconductor on insulator (SeOI) layer.

The device isolation layer 110 may define active regions 105, 205, and 305 in the substrate 101. The device isolation layer 110 may be formed, for example, by a shallow trench isolation (STI) process. In one or more embodiments, the device isolation layer 110 may further comprise a region extending deeper with a step difference into a lower portion of the substrate 101.

The device isolation layer 110 may partially expose an upper portion of the active regions 105, 205, and 305. In one or more embodiments, the device isolation layer 110 may have a wavy upper surface having a level increasing toward the active regions 105, 205, and 305. The device isolation layer 110 may be formed of an insulating material. The device isolation layer 110 may be, for example, oxide, nitride, or a combination thereof.

Referring to FIGS. 2A, 2B, and 2C, the first NMOS transistor structure nTRS1 may comprise a first NMOS channel structure 140 including a plurality of first NMOS channel layers 141, 142, and 143 vertically spaced apart from each other on the first active region 105, a first NMOS source/drain epitaxial layer 150 in contact with the plurality of first NMOS channel layers 141, 142, and 143, a first NMOS gate structure 160 extending by intersecting the first active region 105, and a first NMOS contact plug 180 connected to the first NMOS source/drain epitaxial layer 150. The first NMOS transistor structure nTRS1 may further comprise a first NMOS lower spacer layer 170.

In the first NMOS transistor structure nTRS1, the first active region 105 may have a fin structure, and the first NMOS gate electrode layer 163 may be disposed between the first active region 105 and the first NMOS channel structure 140, between the plurality of first NMOS channel layers 141, 142, and 143 of the first NMOS channel structures 140, and on the first NMOS channel structure 140. Accordingly, the first NMOS transistor structure nTRS1 may comprise a gate-all-around type field effect transistor (GAAFET), that is, a multi-bridge channel FET (MBCFET), by the first NMOS channel structure 140, the first NMOS source/drain epitaxial layer 150, and the first NMOS gate structure 160. The transistor may be, for example, NMOS transistors.

The first active region 105 may be defined by the device isolation layer 110 in the substrate 101 and may be disposed to extend in the first horizontal direction X. The first active region 105 may have a structure protruding from the substrate 101. An upper end of the first active region 105 may be disposed to protrude from an upper surface of the device isolation layer 110 by a predetermined height. The first active region 105 may be formed as a portion of the substrate 101 and may comprise an epitaxial layer grown from the substrate 101. On both sides of the first NMOS gate structure 160, the first active region 105 on the substrate 101 may be partially recessed, and a first NMOS source/drain epitaxial layer 150 may be disposed on the recessed first active region 105. The first active region 105 may comprise impurities or may comprise doped regions including impurities.

The first NMOS channel structure 140 may comprise two or more channel layers spaced apart from each other in a direction perpendicular to an upper surface of the first active region 105, for example, in the vertical direction Z, on the first active region 105. The first NMOS channel structure 140 may be connected to the first NMOS source/drain epitaxial layer 150, and may be spaced apart from an upper surface of the first active region 105. The first NMOS channel structure 140 may have a width the same as or similar to that of the first active region 105 in the second horizontal direction Y, and may have a width the same as or similar to that of the first NMOS gate structure 160 in the first horizontal direction X. However, in one or more embodiments, the first NMOS channel structure 140 may have a reduced width such that side surfaces of the first NMOS channel structure 140 may be positioned on a lower portion of the first NMOS gate structure 160 in the first horizontal direction X (e.g., in a cross-section along the first horizontal direction X).

The first NMOS channel structure 140 may comprise a first NMOS lower channel layer 141 on the first active region 105, a first NMOS intermediate channel layer 142 on the first NMOS lower channel layer 141, and a first NMOS upper channel layer 143 on the first NMOS intermediate channel layer 142. In FIGS. 2A, 2B, and 2C, the number of the channel layers in the first NMOS channel structure 140 may be three, but an example embodiment thereof is not limited thereto. For example, the first NMOS channel structure 140 may comprise four or more channel layers stacked and spaced apart from each other in the vertical direction Z.

The first NMOS channel structure 140 may be formed of a semiconductor material, for example, silicon (Si). The first NMOS channel structure 140 may be formed of, for example, the same material as that of the substrate 101. The number of the first NMOS channel layers 141, 142, and 143 in the first NMOS channel structure 140 and the shape thereof may be varied in one or more embodiments. For example, in one or more embodiments, the first NMOS channel structure 140 may further comprise a channel layer disposed on an upper surface of the first active region 105.

The first NMOS source/drain epitaxial layer 150 may be disposed on the first active region 105 on at least one side of the first NMOS gate structure 160. The first NMOS source/drain epitaxial layer 150 may be disposed in a recess region, which may be recessed from an upper surface of the first active region 105. As for the shape of the recess region of the first active region 105, the degree of downward curvature may be varied in one or more embodiments. Accordingly, the shape of the first NMOS source/drain epitaxial layer 150 formed in the recess region of the first active region 105 may also be varied.

The first NMOS source/drain epitaxial layer 150 may be spaced apart from each other in the first horizontal direction X. The first NMOS source/drain epitaxial layer 150 may have an N-type conductivity. The first NMOS source/drain epitaxial layer 150 may comprise an epitaxially grown semiconductor material. For example, the first NMOS source/drain epitaxial layer 150 may comprise silicon.

The first NMOS source/drain epitaxial layer 150 may comprise a plurality of epitaxial layers, for example, may comprise first to third epitaxial layers 151, 152, and 153. However, the first to third epitaxial layers 151, 152, 153 are an example, and an example embodiment thereof is not limited thereto, and the first NMOS source/drain epitaxial layer 150 may comprise three or more epitaxial layers.

The first epitaxial layer 151 may extend to be in contact with a plurality of first NMOS channel layers 141, 142, and 143. The first epitaxial layer 151 may be in contact with a lower portion 160B of a first NMOS gate structure 160 disposed below each of the first NMOS channel layers 141, 142, and 143. Side surfaces of the plurality of first NMOS channel layers 141, 142, and 143 and a side surface of the lower portion 160B of the first NMOS gate structure 160 may be covered. The first epitaxial layer 151 may be disposed between the second epitaxial layer 152 and the side surfaces of a plurality of first NMOS channel layers 141, 142, and 143, and between the second epitaxial layer 152 and the side surface of the first NMOS gate structure 160.

The first epitaxial layer 151 may comprise a protrusion protruding toward the first NMOS gate structure 160 at the same level as a level of the lower portion 160B of the first NMOS gate structure 160. In one or more embodiments, a side surface in the first horizontal direction X of the lower portion 160B of the first NMOS gate structure 160 may be recessed to a predetermined depth and may have an inwardly curved shape. A protrusion of the first epitaxial layer 151 may be disposed in the recessed region of the lower portion 160B of the first NMOS gate structure 160. A width in the first horizontal direction X of the first epitaxial layer 151 at the level of the first NMOS gate structure 160 (e.g., the lower portion 160B of the first NMOS gate structure 160) may be greater than a width in the first horizontal direction X of the first epitaxial layer 151 at the level of the first NMOS lower channel layer 141, the first NMOS intermediate channel layer 142 and the first NMOS upper channel layer 143.

The surface on which the first epitaxial layer 151 is in contact with the plurality of first NMOS channel layers 141, 142, and 143 and the lower portion 160B of the first NMOS gate structure 160 may have a wavy shape, but an example embodiment thereof is not limited thereto. The shape of the first epitaxial layer 151 may be varied depending on the shape of the first NMOS channel structure 140, the shape of the first NMOS gate structure 160, or the like. For example, when the semiconductor device further comprises an external side spacer (not illustrated) on the external side of the gate electrode layer (e.g., the first NMOS gate electrode layer 163) of the lower portion 160B, the external side surface of the first epitaxial layer 151 may have a gently curved shape.

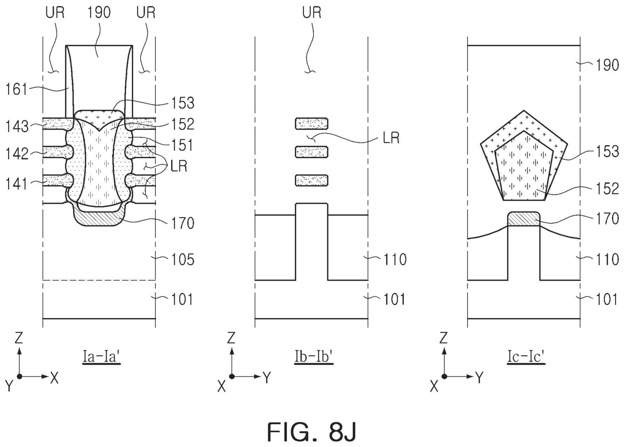

The first epitaxial layer 151 may comprise silicon (Si) doped with a group 15 element and may have an N-type conductivity. For example, the first epitaxial layer 151 may comprise one of phosphorus (P), arsenic (As), antimony (Sb), and bismuth (Bi) as a doping element. The first epitaxial layer 151 may have an etching selectivity lower than that of the sacrificial layer 120 under specific etching conditions during a manufacturing process. Due to the difference in etching selectivity, in the process in FIG. 8J described below, the sacrificial layer 120 may be selectively removed, and the first NMOS source/drain epitaxial layer 150 surrounded by the first epitaxial layer 151 may remain.

The second epitaxial layer 152 may be disposed on the first epitaxial layer 151. The second epitaxial layer 152 may be disposed on the first NMOS lower spacer layer 170. The second epitaxial layer 152 may have an upper surface 152US having a recessed shape. In one or more embodiments, an upper surface 152US of the second epitaxial layer 152 may have an angular shape, or may have an almost U-shape, a rounded shape. An uppermost end of the second epitaxial layer 152 may be disposed at substantially the same level as an uppermost end of the first epitaxial layer 151.

The second epitaxial layer 152 may comprise silicon (Si) doped with a group 15 element and may have an N-type conductivity. For example, the second epitaxial layer 152 may comprise one of phosphorus (P), arsenic (As), antimony (Sb), and bismuth (Bi) as a doping element. A doping concentration of the second epitaxial layer 152 may be higher than a doping concentration of the first epitaxial layer 151. For example, an impurity concentration of the first epitaxial layer 151 may be lower than an impurity concentration of the second epitaxial layer 152. For example, a concentration of phosphorus (P) in the first epitaxial layer 151 may be lower than a concentration of phosphorus (P) in the second epitaxial layer 152.

The third epitaxial layer 153 may be disposed on the second epitaxial layer 152. The third epitaxial layer 153 may be in contact with a portion of an upper surface of the first epitaxial layer 151 and an upper surface 152US of the second epitaxial layer 152. In one or more embodiments, at least a portion of the third epitaxial layer 153 (e.g., at least a portion of an upper surface 153US of the third epitaxial layer 153) may be at a level higher than a level of an upper surface of the uppermost channel layer (e.g., the first NMOS upper channel layer 143), but is not limited thereto. In one or more embodiments, at least a portion of the third epitaxial layer 153 (e.g., at least a portion of the upper surface 153US of the third epitaxial layer 153) may be coplanar with the upper surface of the uppermost channel layer (e.g., the first NMOS upper channel layer 143).

The first to third epitaxial layers 151, 152, and 153 may comprise silicon (Si) doped with a group 15 element. In one or more embodiments, the first to third epitaxial layers 151, 152, and 153 may have an N-type conductivity. For example, the first to third epitaxial layers 151, 152, and 153 may have different concentrations of phosphorus (P). The concentration of phosphorus (P) in the second epitaxial layer 152 may be higher than concentration of phosphorus (P) in the first epitaxial layer 151 and the third epitaxial layer 153 (e.g., each of the first epitaxial layer 151 and the third epitaxial layer 153).

The third epitaxial layer 153 may be a protective layer capping the first and second epitaxial layers 151 and 152.

Referring to FIG. 2C, the concentration of phosphorus (P) may increase in the order of the first region P1, the second region P2, and the third region P3 in the first NMOS source/drain epitaxial layer 150. In an example embodiment, the phosphorus (P) concentration of the second epitaxial layer 152 may increase in the direction toward the second portion 170P2 of the first NMOS lower spacer layer 170. For example, the phosphorus (P) concentration of the second epitaxial layer 152 may be the highest in or at the lower surface 152BS of the second epitaxial layer 152.

By forming such that the phosphorus (P) concentration in the first NMOS source/drain epitaxial layer 150 increases downwardly in the vertical direction Z, electrical properties of the first NMOS source/drain epitaxial layer 150 may be improved. Particularly, since a region doped with phosphorus (P) at a high concentration is present in the third region P3, contact resistance may be reduced and the carrier injection efficiency may be improved.

Also, the first region P1 doped with phosphorus (P) in a relatively low concentration may alleviate electric field concentration in proximity of a bonding region bonded with the first NMOS upper channel layer 143, thereby reducing leakage current. This doping concentration gradient may improve reliability of the semiconductor device and may also be advantageous for controlling a doping profile due to diffusion during a process.

The first NMOS gate structure 160 may be disposed to extend in one direction, for example, the second horizontal direction Y, by intersecting the first active region 105 and the first NMOS channel structures 140 on the first active region 105 and the first NMOS channel structures 140. A channel region of transistors may be formed in the first active region 105 and the first NMOS channel structures 140 intersecting the first NMOS gate structure 160.

The first NMOS gate structure 160 may comprise a first NMOS gate spacer layer 161, a first NMOS gate dielectric layer 162, a first NMOS gate electrode layer 163 and a first NMOS gate capping layer 164. The first NMOS gate structure 160 may comprise the first NMOS gate electrode layer 163, the first NMOS gate dielectric layer 162 between the first NMOS gate electrode layer 163 and the plurality of first NMOS channel layers 141, 142, and 143, the first NMOS gate spacer layers 161 on side surfaces of the first NMOS gate electrode layer 163, and the first NMOS gate capping layer 164 on an upper surface of the first NMOS gate electrode layer 163.

The first NMOS gate spacer layers 161 may be formed as a multilayer structure in one or more embodiments. The first NMOS gate spacer layers 161 may comprise at least one of an oxide, a nitride, an oxynitride, and a low-κ dielectric.

The first NMOS gate dielectric layer 162 may be disposed between the first active region 105 and the first NMOS gate electrode layer 163 and between the first NMOS channel structure 140 and the first NMOS gate electrode layer 163, and may be disposed to cover at least a portion of surfaces of the first NMOS gate electrode layer 163. For example, the first NMOS gate dielectric layer 162 may be disposed to surround the entirety of surfaces other than an uppermost surface of the first NMOS gate electrode layer 163. The first NMOS gate dielectric layer 162 may extend between the first NMOS gate electrode layer 163 and the first NMOS gate spacer layers 161, but an example embodiment thereof is not limited thereto.

The first NMOS gate dielectric layer 162 may comprise oxide, nitride, or a high-κ material. The high-κ material may indicate a dielectric material having a dielectric constant higher than that of a silicon oxide (SiO₂). The high-κ material may be, for example, one of aluminum oxide (Al₂O₃), tantalum oxide (Ta₂O₃), titanium oxide (TiO₂), yttrium oxide (Y₂O₃), zirconium oxide (ZrO₂), zirconium silicon oxide (ZrSiₓO_{y}), hafnium oxide (HfO₂), hafnium silicon oxide (HfSiₓO_{y}), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}), and praseodymium oxide (Pr₂O₃).

The first NMOS gate electrode layer 163 may fill a region between the plurality of first NMOS channel layers 141, 142, and 143 on the first active region 105, and may extend onto the first NMOS channel structure 140. The first NMOS gate electrode layer 163 may be spaced apart from the plurality of first NMOS channel layers 141, 142, and 143 by the first NMOS gate dielectric layer 162.

The first NMOS gate electrode layer 163 may comprise a conductive material. For example, the first NMOS gate electrode layer 163 may comprise at least one of a metal nitride (e.g., at least one of titanium nitride (TiN), tantalum nitride (TaN), and tungsten nitride (WN)), a metal material (e.g., at least one of aluminum (Al), tungsten (W), and molybdenum (Mo)) and silicon (e.g., doped polysilicon).

The first NMOS gate electrode layer 163 may comprise two or more layers (e.g., multiple layers). The first NMOS gate spacer layers 161 may be disposed on both surfaces (e.g., both side surfaces) of the first NMOS gate electrode layer 163. The first NMOS gate spacer layers 161 may insulate the first NMOS source/drain epitaxial layer 150 and the first NMOS gate electrode layer 163 from each other.

The first NMOS gate capping layer 164 may be disposed on an upper portion of the first NMOS gate electrode layer 163, and the lower surface of the first NMOS gate capping layer 164 may be surrounded by the first NMOS gate electrode layer 163 and the first NMOS gate spacer layers 161.

The first NMOS lower spacer layer 170 may be disposed below the first NMOS source/drain epitaxial layer 150. A level of an upper end of the first NMOS lower spacer layer 170 may be higher than a level of a lower surface of the first NMOS gate structure 160. The level of the upper end of the first NMOS lower spacer layer 170 may be higher than a level of a lower surface of the first NMOS gate electrode layer 163 (e.g., the lowermost portion of the first NMOS gate electrode layer 163). The level of the upper end of the first NMOS lower spacer layer 170 may be higher than a level of an upper surface of the first NMOS gate electrode layer 163. The level of the upper end of the first NMOS lower spacer layer 170 may be substantially the same as a level of a lower surface of the first NMOS lower channel layer 141.

A maximum thickness 170t in the vertical direction Z of the first NMOS lower spacer layer 170 may be a maximum thickness 170t in the vertical direction Z of the second portion 170P2 of the first NMOS lower spacer layer 170. A maximum thickness 170t in the vertical direction Z of the first NMOS lower spacer layer 170 may be greater than a maximum thickness 270t in the vertical direction Z of the second NMOS lower spacer layer 270, and a maximum thickness 370t in the vertical direction Z of the third NMOS lower spacer layer 170.

The first NMOS lower spacer layer 170 may comprise an insulating nitride, for example, at least one of SiO, SiN, SiCN, SiOC, SiON, and SiOCN. For example, the first NMOS lower spacer layer 170 may comprise silicon nitride. The first NMOS lower spacer layer 170 may comprise a material different from that of the first NMOS source/drain epitaxial layer 150. However, an example embodiment thereof is not limited thereto.

The first NMOS lower spacer layer 170 may comprise a first portion 170P1 extending between the first NMOS gate dielectric layer 162 of the first NMOS gate structure 160 disposed in a lowermost portion of the first NMOS gate structure 160 and the first NMOS source/drain epitaxial layer 150 and a second portion 170P2 disposed between the first active region 105 and the first NMOS source/drain epitaxial layer 150.

The first portion 170P1 of the first NMOS lower spacer layer 170 may be in contact with at least a portion of the first epitaxial layer 151. The first portion 170P1 of the first NMOS lower spacer layer 170 may be spaced apart from the second epitaxial layer 152. The first epitaxial layer 151 may be disposed between the first portion 170P1 of the first NMOS lower spacer layer 170 and the second epitaxial layer 152.

The second portion 170P2 of the first NMOS lower spacer layer 170 may be spaced apart from the first epitaxial layer 151. The second portion 170P2 of the first NMOS lower spacer layer 170 may be spaced apart from the lower surface 152BS of the second epitaxial layer 152.

The first portion 170P1 of the first NMOS lower spacer layer 170 and the first epitaxial layer 151 may be in direct contact with each other.

The first portion 170P1 of the first NMOS lower spacer layer 170 may extend between the first NMOS gate dielectric layer 162 and the first NMOS source/drain epitaxial layer 150, and may comprise a lower surface 170S1 in contact with the first NMOS gate dielectric layer 162 and an upper surface 170S2 in contact with the first NMOS source/drain epitaxial layer 150.

The first NMOS lower spacer layer 170 may effectively prevent a locally deep pitting pass in a portion of the first NMOS source/drain epitaxial layer 150 and the first active region 105 during a process of removing silicon germanium (SiGe) sacrificial layers 120 for a gate structure. Particularly, when precise maintenance of the facet of the source/drain region is required in a fine process, the structure may prevent damage to the epitaxial layer, thereby improving a process margin. The first NMOS lower spacer layer 170 may function as a protective layer of the source/drain region, rather than a simple structural boundary layer, as described above.

The first NMOS lower spacer layer 170 may be disposed on a lower portion of a source/drain, and may form a physical boundary layer with the first active region 105, thereby effectively blocking leakage current through the first active region 105. Accordingly, stable operation may be ensured in a highly integrated logic circuit or a SRAM.

Also, the first NMOS lower spacer layer 170 may physically restrict a diffusion of a high-concentration doping profile of the third region P3 of the first NMOS source/drain epitaxial layer 150 into the first active region 105, thereby improving doping uniformity and bonding precision during a process, and ensuring long-term reliability.

The first void V1 may be disposed between the second portion 170P2 of the first NMOS lower spacer layer 170 and the first NMOS source/drain epitaxial layer 150. The first void V1 may comprise air having a relatively low dielectric constant.

The first void V1 may be disposed to be completely enclosed by the first NMOS source/drain epitaxial layer 150 and the first NMOS lower spacer layer 170. That is, by a portion of an internal side surface of the first NMOS lower spacer layer 170 surrounding the side surface of the first void V1 and the lower surface 152BS of the second epitaxial layer 152 covering an upper surface of the first void V1, the first void V1 may have an independent space between the first NMOS lower spacer layer 170 and the second epitaxial layer 152, and the first NMOS lower spacer layer 170 may be spaced apart from the second epitaxial layer 152. Also, the lower surface 152BS of the second epitaxial layer 152 and at least a portion of the side surfaces of the first NMOS lower spacer layer 170, surrounding the first void V1 may be exposed by the first void V1.

The first void V1 may be formed between the second portion 170P2 of the first NMOS lower spacer layer 170 and the first NMOS source/drain epitaxial layer 150, and may strengthen insulating properties of the first NMOS lower spacer layer 170. For example, the first void V1 filled with a medium having a relatively low dielectric constant (κ-value) such as air may be effective in reducing electrical coupling and reducing parasitic capacitance. The first void V1 may be advantageously used in a circuit environment requiring high-speed signal transmission and low-power operation.

The first interlayer insulating layer 190 may be disposed to cover the first NMOS source/drain epitaxial layer 150, the first NMOS gate structure 160, and the device isolation layer 110. The first interlayer insulating layer 190 may comprise, for example, at least one of an oxide, a nitride, an oxynitride, and a low-κ dielectric.

The first NMOS contact plug 180 may penetrate the first interlayer insulating layer 190 and may be connected to the first NMOS source/drain epitaxial layer 150, and may apply an electrical signal to the first NMOS source/drain epitaxial layer 150. The first NMOS contact plug 180 may be disposed on the first NMOS source/drain epitaxial layer 150, and in one or more embodiments, the first NMOS contact plug 180 may be disposed to have a relatively longer length along the second horizontal direction Y than that of the first NMOS source/drain epitaxial layer 150. The first NMOS contact plug 180 may have an inclined side surface in which a width of a lower portion is less than a width of an upper portion depending on an aspect ratio, but an example embodiment thereof is not limited thereto. The first NMOS contact plug 180 may be disposed to be recessed into the first NMOS source/drain epitaxial layer 150 to a predetermined depth.

In an example embodiment, the first NMOS contact plug 180 may be disposed to penetrate the third epitaxial layer 153 and at least a portion of the second epitaxial layer 152.

The first NMOS contact plug 180 may comprise, for example, at least one of a metal nitride (e.g., at least one of titanium nitride (TiN), tantalum nitride (TaN), and tungsten nitride (WN)) and a metal material (e.g., at least one of aluminum (Al), tungsten (W), and molybdenum (Mo)).

Referring to FIGS. 3A and 3B, the second NMOS transistor structure nTRS2 may comprise a second NMOS channel structure 240 including a plurality of second NMOS channel layers 241, 242, and 243 vertically spaced apart from each other on the second active region 205, a second NMOS source/drain epitaxial layer 250 in contact with the plurality of second NMOS channel layers 241, 242, and 243, a second NMOS gate structure 260 extending across the second active region 205, and a second NMOS contact plug 280 connected to the second NMOS source/drain epitaxial layer 250. The second NMOS transistor structure nTRS2 may further comprise a second NMOS lower spacer layer 270.

The second active region 205 in the second NMOS transistor structure nTRS2 may be configured the same as or similar to the first active region 105 in the first NMOS transistor structure nTRS1 described with reference to FIGS. 2A, 2B, and 2C, unless otherwise indicated below.

The second NMOS channel structure 240 in the second NMOS transistor structure nTRS2 may be configured the same as or similar to the first NMOS channel structure 140 in the first NMOS transistor structure nTRS1 described with reference to FIGS. 2A, 2B, and 2C, unless otherwise indicated below.

The second NMOS source/drain epitaxial layer 250 in the second NMOS transistor structure nTRS2 may be configured the same as or similar to the first NMOS source/drain epitaxial layer 150 in the first NMOS transistor structure nTRS1 described with reference to FIGS. 2A, 2B, and 2C, unless otherwise indicated below.

The second NMOS gate structure 260 in the second NMOS transistor structure nTRS2 may be configured the same as or similar to the first NMOS gate structure 160 in the first NMOS transistor structure nTRS1 described with reference to FIGS. 2A, 2B, and 2C, unless otherwise indicated below.

The second NMOS contact plug 280 in the second NMOS transistor structure nTRS2 may be configured the same as or similar to the first NMOS contact plug 180 in the first NMOS transistor structure nTRS1 described with reference to FIGS. 2A, 2B, and 2C, unless otherwise indicated below.

The second NMOS channel structure 240 may be disposed at the same level as the first NMOS channel structure 140. The second NMOS channel structure 240 may comprise a second NMOS lower channel layer 241 on the second active region 205, a second NMOS intermediate channel layer 242 on the second NMOS lower channel layer 241, and a second NMOS upper channel layer 243 on the second NMOS intermediate channel layer 242. In FIGS. 3A and 3B, the number of the channel layers of the second NMOS channel structure 240 may be three, but an example embodiment thereof is not limited thereto. For example, the second NMOS channel structure 240 may comprise four or more channel layers stacked and spaced apart from each other in the vertical direction Z.

A width in the first horizontal direction X of a channel layer disposed at a first level of the second NMOS channel layers 241, 242, and 243 of the second NMOS channel structure 240 may be greater than a width in the first horizontal direction X of a channel layer disposed at the first level of the first NMOS channel layers 141, 142, and 143 of the first NMOS channel structure 140. The first level may be a level in the vertical direction Z.

For example, the width in the first horizontal direction X of the second NMOS intermediate channel layer 242 may be greater than the width in the first horizontal direction X of the first NMOS intermediate channel layer 142, disposed at the same level as the second NMOS intermediate channel layer 242. The second NMOS gate structure 260 may extend in the second horizontal direction Y and may surround the second NMOS channel structure 240 (e.g., surround the plurality of second NMOS channel layers 241, 242, and 243 of the second NMOS channel structure 240, respectively). The second NMOS gate structure 260 may surround the second NMOS channel structure 240, may extend in the second horizontal direction Y, and may be disposed on the second active region 205 and the device isolation layer 110.

A width in the first horizontal direction X of the second NMOS source/drain epitaxial layer 250 may be greater than a width in the first horizontal direction X of the first NMOS source/drain epitaxial layer 150. A maximum width in the first horizontal direction X of the second NMOS source/drain epitaxial layer 250 may be greater than a maximum width in the first horizontal direction X of the first NMOS source/drain epitaxial layer 150.

The second NMOS source/drain epitaxial layer 250 may comprise a plurality of epitaxial layers, for example, fourth to sixth epitaxial layers 251, 252, and 253. However, the fourth to sixth epitaxial layers 251, 252, and 253 are merely an example, and an example embodiment thereof is not limited thereto, and the second NMOS source/drain epitaxial layer 250 may comprise three or more epitaxial layers.

The fourth epitaxial layer 251 may extend to be in contact with the plurality of second NMOS channel layers 241, 242, and 243. The fourth epitaxial layer 251 may be in contact with a lower portion 260B of a second NMOS gate structure 260 disposed below each of the second NMOS channel layers 241, 242, and 243. For example, the fourth epitaxial layer 251 may comprise a side surface 251S in contact with the lower portion 260B of the second NMOS gate structure 260.

The fifth epitaxial layer 252 may be disposed on the fourth epitaxial layer 251.

The sixth epitaxial layer 253 may be a protective layer capping the fourth and fifth epitaxial layers 251 and 252.

Referring to FIG. 2C together, a concentration of phosphorus (P) may increase in the second NMOS source/drain epitaxial layer 250 in the order of regions corresponding to the first region P1, the second region P2, and the third region P3 in the first NMOS source/drain epitaxial layer 150.

The second NMOS gate structure 260 may comprise a second NMOS gate spacer layer 261, a second NMOS gate dielectric layer 262, a second NMOS gate electrode layer 263, and a second NMOS gate capping layer 264. The second NMOS gate structure 260 may comprise a second NMOS gate electrode layer 263, a second NMOS gate dielectric layer 262 between the second NMOS gate electrode layer 263 and the plurality of second NMOS channel layers 241, 242, and 243, a second NMOS gate spacer layer 261 on side surfaces of the second NMOS gate electrode layer 263, and a second NMOS gate capping layer 264 on an upper surface of the second NMOS gate electrode layer 263.

The second NMOS lower spacer layer 270 may be disposed below the second NMOS source/drain epitaxial layer 250. A level of an upper end of the second NMOS lower spacer layer 270 may be higher than a level of a lower surface of the second NMOS gate structure 260. A level of an upper end of the second NMOS lower spacer layer 270 may be higher than a level of a lower surface of the second NMOS gate electrode layer 263. A level of an upper end of the second NMOS lower spacer layer 270 may be lower than a level of an upper surface of the second NMOS gate electrode layer 263 (e.g., the lowermost portion of the second NMOS gate electrode layer 263). The second NMOS lower spacer layer 270 may be in contact with a side surface of the lower portion 260B disposed in a lowest portion of the second NMOS gate structure 260.

A maximum thickness 270t in the vertical direction Z of the second NMOS lower spacer layer 270 may be a maximum thickness 270t in the vertical direction Z of the second portion 270P2 of the second NMOS lower spacer layer 270. A maximum thickness 270t in the vertical direction Z of the second NMOS lower spacer layer 270 may be greater than a maximum thickness 370t in the vertical direction Z of the third NMOS lower spacer layer 370. In one or more embodiments, a maximum width in the vertical direction Z of the second NMOS lower spacer layer 270 may be less than a maximum width in the vertical direction Z of the first NMOS lower spacer layer 170.

The second NMOS lower spacer layer 270 may comprise an insulating nitride, for example, at least one of SiO, SiN, SiCN, SiOC, SiON, and SiOCN. For example, the second NMOS lower spacer layer 270 may be formed of silicon nitride. The second NMOS lower spacer layer 270 may comprise a different material from a material of the second NMOS source/drain epitaxial layer 250. However, an example embodiment thereof is not limited thereto.

The second NMOS lower spacer layer 270 may comprise a first portion 270P1 disposed between the second NMOS gate dielectric layer 262 of the second NMOS gate structure 260 disposed in a lowermost portion of the second NMOS gate structure 260 and the second NMOS source/drain epitaxial layer 250, and a second portion 270P2 disposed between the second active region 205 and the second NMOS source/drain epitaxial layer 250.

The first portion 270P1 of the second NMOS lower spacer layer 270 may be in contact with at least a portion of the fourth epitaxial layer 251. The first portion 270P1 of the second NMOS lower spacer layer 270 may be spaced apart from the fifth epitaxial layer 252. The fourth epitaxial layer 251 may be disposed between the first portion 270P1 of the second NMOS lower spacer layer 270 and the fifth epitaxial layer 252.

The second portion 270P2 of the second NMOS lower spacer layer 270 may be spaced apart from the fourth epitaxial layer 251. The second portion 270P2 of the second NMOS lower spacer layer 270 may be spaced apart from the lower surface 252BS of the fifth epitaxial layer 252.

The first portion 270P1 of the second NMOS lower spacer layer 270 and the fourth epitaxial layer 251 may be in direct contact with each other.

The first portion 270P1 of the second NMOS lower spacer layer 270 may extend between the second NMOS gate dielectric layer 262 and the second NMOS source/drain epitaxial layer 250, and may comprise a lower surface 270S1 in contact with the second NMOS gate dielectric layer 262 and an upper surface 270S2 in contact with the second NMOS source/drain epitaxial layer 250.

Differently from the first NMOS transistor structure nTRS1, the second NMOS transistor structure nTRS2 may have a relatively wide distance in the first horizontal direction X in which the second NMOS source/drain epitaxial layer 250 is formed, such that, even when the first portion 270P1 is only partially in contact with the side surface of the lower portion 260B of the second NMOS gate structure 260, pitting pass which may occur during a process of removing the silicon germanium (SiGe) sacrificial layer may be effectively prevented.

Under conditions in which structural density and shape constraints are relaxed, even when the lower spacer layer is not in direct contact with the gate dielectric layer in a partial section, a lower portion of the source/drain epitaxial layer may be protected and etch damage may be prevented. This characteristic may increase process flexibility and shape design freedom, and may contribute to maintaining device reliability under various pattern conditions.

The second void V2 may be disposed between the second portion 270P2 of the second NMOS lower spacer layer 270 and the second NMOS source/drain epitaxial layer 250. The second void V2 may contain air having a relatively low dielectric constant.

The second void V2 may be disposed to be completely enclosed by the second NMOS source/drain epitaxial layer 250 and the second NMOS lower spacer layer 270. That is, by the second portion 270P2 of the second NMOS lower spacer layer 270 enclosing the side surface of the second void V2 and the lower surface 252BS of the fifth epitaxial layer 252 covering the upper surface of the second void V2, the second void V2 may have an independent space between the second NMOS lower spacer layer 270 and the fifth epitaxial layer 252, and the second NMOS lower spacer layer 270 may be spaced apart from the fifth epitaxial layer 252. Also, the lower surface 252BS of the fifth epitaxial layer 252 and at least a portion of side surfaces of the second NMOS lower spacer layer 270, surrounding the second void V2 may be exposed by the second void V2.

The second void V2 may have a greater width in the first and second horizontal directions X and Y, and may have a larger thickness in the vertical direction Z, than the first void V1.

A plurality of second NMOS channel layers 241, 242, and 243 may comprise a second NMOS lower channel layer 241 disposed in a lowermost portion, and an upper end of the second NMOS lower spacer layer 270 may be positioned at a level lower than a level of a lower surface of the second NMOS lower channel layer 241.

A second interlayer insulating layer 290 may be disposed to cover the second NMOS source/drain epitaxial layer 250, the second NMOS gate structure 260, and the device isolation layer 110. The second interlayer insulating layer 290 may comprise the same material as that of the first interlayer insulating layer 190.

The second NMOS contact plug 280 may be connected to the second NMOS source/drain epitaxial layer 250 by penetrating the second interlayer insulating layer 290, and may apply an electrical signal to the second NMOS source/drain epitaxial layer 250. In an example embodiment, the second NMOS contact plug 280 may penetrate the sixth epitaxial layer 253 and may penetrate at least a portion of the fifth epitaxial layer 252

Referring to FIGS. 4A and 4B, the third NMOS transistor structure nTRS3 may comprise a third NMOS channel structure 340 including a plurality of third NMOS channel layers 341, 342, and 343 vertically spaced apart from each other on the third active region 305, a third NMOS source/drain epitaxial layer 350 in contact with the plurality of third NMOS channel layers 341, 342, and 343, a third NMOS gate structure 360 extending across the third active region 305, and a third NMOS contact plug 380 connected to the third NMOS source/drain epitaxial layer 350. The third NMOS transistor structure nTRS3 may further comprise the third NMOS lower spacer layer 370.

The third active region 305 in the third NMOS transistor structure nTRS3 may be configured the same as or similar to the first active region 105 in the first NMOS transistor structure nTRS1 described with reference to FIGS. 2A, 2B, and 2C, unless otherwise indicated below.

The third NMOS channel structure 340 in the third NMOS transistor structure nTRS3 may be configured the same as or similar to the first NMOS channel structure 140 in the first NMOS transistor structure nTRS1 described with reference to FIGS. 2A, 2B, and 2C, unless otherwise indicated below.

The third NMOS source/drain epitaxial layer 350 in the third NMOS transistor structure nTRS3 may be configured the same as or similar to the first NMOS source/drain epitaxial layer 150 in the first NMOS transistor structure nTRS1 described with reference to FIGS. 2A, 2B, and 2C, unless otherwise indicated below.

The third NMOS gate structure 360 in the third NMOS transistor structure nTRS3 may be configured the same as or similar to the first NMOS gate structure 160 in the first NMOS transistor structure nTRS1 described with reference to FIGS. 2A, 2B, and 2C, unless otherwise indicated below.

The third NMOS contact plug 380 in the third NMOS transistor structure nTRS3 may be configured the same as or similar to the first NMOS contact plug 180 in the first NMOS transistor structure nTRS1 described with reference to FIGS. 2A, 2B, and 2C, unless otherwise indicated below.

The third NMOS channel structure 340 may be disposed at the same level as the first NMOS channel structure 140. The third NMOS channel structure 340 may comprise a third NMOS lower channel layer 341 on the third active region 305, a third NMOS intermediate channel layer 342 on the third NMOS lower channel layer 341, and a third NMOS upper channel layer 343 on the third NMOS intermediate channel layer 342. In FIGS. 4A and 4B, the number of the channel layers of the third NMOS channel structure 340 may be three, but an example embodiment thereof is not limited thereto. For example, the third NMOS channel structure 340 may comprise four or more channel layers stacked and spaced apart from each other in the vertical direction Z.

A width in the first horizontal direction X of a channel layer disposed at the first level of the third NMOS channel layers 341, 342, and 343 among the third NMOS channel structure 340 may be greater than a width in the first horizontal direction X of a channel layer disposed at the first level of the first NMOS channel layers 141, 142, and 143 among the first NMOS channel structure 140.

For example, the width in the first horizontal direction X of the third NMOS intermediate channel layer 342 may be greater than the width in the first horizontal direction X of the second NMOS intermediate channel layer 242 disposed at the same level as the third NMOS intermediate channel layer 342. The third NMOS gate structure 360 may extend in the second horizontal direction Y and may surround the third NMOS channel structure 340. The third NMOS gate structure 360 may extend in the second horizontal direction Y by surrounding the third NMOS channel structure 340, and may be disposed on the third active region 305 and device isolation layer 110.

The width in the first horizontal direction X of the third NMOS source/drain epitaxial layer 350 may be greater than the width in the first horizontal direction X of the first NMOS source/drain epitaxial layer 150. A maximum width in the first horizontal direction X of the third NMOS source/drain epitaxial layer 350 may be greater than a maximum width in the first horizontal direction X of the first NMOS source/drain epitaxial layer 150.

The third NMOS source/drain epitaxial layer 350 may comprise a plurality of epitaxial layers, for example, seventh to ninth epitaxial layers 351, 352, and 353. **For** example, the seventh to ninth epitaxial layers 351, 352, and 353 may be comprised. However, the seventh to ninth epitaxial layers 351, 352, and 353 are an example, but an example embodiment thereof is not limited thereto, and the third NMOS source/drain epitaxial layer 350 may comprise three or more epitaxial layers.

The seventh epitaxial layer 351 may extend to be in contact with a plurality of third NMOS channel layers 341, 342, and 343. The seventh epitaxial layer 351 may be in contact with a lower portion 360B of a third NMOS gate structure 360 disposed below each of the third NMOS channel layers 341, 342, and 343. **For** example, the seventh epitaxial layer 351 may comprise a side surface 351S in contact with the lower portion 360B of the third NMOS gate structure 360.

The eighth epitaxial layer 352 may be disposed on the seventh epitaxial layer 351.

The ninth epitaxial layer 353 may be a protective layer capping the seventh and eighth epitaxial layers 351 and 352.

The third NMOS gate structure 360 may comprise a third NMOS gate spacer layer 361, a third NMOS gate dielectric layer 362, a third NMOS gate electrode layer 363 and a third NMOS gate capping layer 364. The third NMOS gate structure 360 may comprise a third NMOS gate electrode layer 363, a third NMOS gate dielectric layer 362 between the third NMOS gate electrode layer 363 and the plurality of third NMOS channel layers 341, 342, and 343, a third NMOS gate spacer layer 361 on side surfaces of the third NMOS gate electrode layer 363, and a third NMOS gate capping layer 364 on an upper surface of the third NMOS gate electrode layer 363.

A level of an upper end of the third NMOS lower spacer layer 370 may be lower than a level of a lower surface of the third NMOS gate structure 360. The level of the upper end of the third NMOS lower spacer layer 370 may be lower than a level of a lower surface of the third NMOS gate electrode layer 363. The level of the upper end of the third NMOS lower spacer layer 370 may be substantially the same as a level of an upper surface of the third active region 305.

A maximum thickness 370t in the vertical direction Z of the third NMOS lower spacer layer 370 may be smaller than a maximum thickness 170t in the vertical direction Z of the first NMOS lower spacer layer 170 and a maximum thickness 270t in the vertical direction Z of the second NMOS lower spacer layer 270. In one or more embodiments, a maximum width in the vertical direction Z of the third NMOS lower spacer layer 370 may be less than the maximum width in the vertical direction Z of the second NMOS lower spacer layer 270.

The third NMOS lower spacer layer 370 may be disposed between the third active region 305 and the third NMOS source/drain epitaxial layer 350. The third NMOS lower spacer layer 370 may be spaced apart from the lower surface 352BS of the eighth epitaxial layer 352. The third NMOS lower spacer layer 370 may comprise an upper surface spaced apart from a lower surface of the third NMOS source/drain epitaxial layer 350.

Differently from the first and second NMOS transistor structures nTRS1 and nTRS2, the third NMOS transistor structure nTRS3 may have a relatively wide distance in the first horizontal direction X in which the third NMOS source/drain epitaxial layer 350 is formed, such that, even when the third NMOS lower spacer layer 370 is not disposed between the side surface of the lower portion 360B of the third NMOS gate structure 360 and the seventh epitaxial layer 351, pitting pass which may occur during a process of removing the silicon germanium (SiGe) sacrificial layer may be effectively prevented.

Under conditions in which structural density and shape constraints are relaxed, even when the lower spacer layer is not in direct contact with the gate dielectric layer in a partial section, a lower portion of the source/drain epitaxial layer may be protected and etching damage may be prevented. These characteristics may increase process flexibility and shape design freedom, and may contribute to maintaining device reliability even under various pattern conditions.

The third void V3 may be disposed between the third NMOS lower spacer layer 370 and the third NMOS source/drain epitaxial layer 350. The third void V3 may comprise air having a low dielectric constant.

The third void V3 may be disposed to be completely surrounded by the third NMOS source/drain epitaxial layer 350 and the third NMOS lower spacer layer 370. That is, by the third NMOS lower spacer layer 370 surrounding the side surface of the third void V3 and the lower surface 352BS of the eighth epitaxial layer 352 covering the upper surface of the third void V3, the third void V3 may have an independent space between the third NMOS lower spacer layer 370 and the eighth epitaxial layer 352, and the third NMOS lower spacer layer 370 may be spaced apart from the eighth epitaxial layer 352. Also, at least a portion of the lower surface 352BS of the eighth epitaxial layer 352 and the side surfaces of the third NMOS lower spacer layer 370, surrounding the third void V3 may be exposed by the third void V3.

The third void V3 may have a greater width in the first and second horizontal directions X and Y and a larger thickness in the vertical direction Z, than the second void V2.

The third interlayer insulating layer 390 may be disposed to cover the third NMOS source/drain epitaxial layer 350, the third NMOS gate structure 360 and the device isolation layer 110. The third interlayer insulating layer 390 may comprise the same material as that of the first interlayer insulating layer 190.

The third NMOS contact plug 380 may be connected to the third NMOS source/drain epitaxial layer 350 by penetrating the third interlayer insulating layer 390, and may apply an electrical signal to the third NMOS source/drain epitaxial layer 350. In an example embodiment, the third NMOS contact plug 380 may penetrate the ninth epitaxial layer 353 and may penetrate at least a portion of the eighth epitaxial layer 352.

An upper end of the second NMOS lower spacer layer 270 may be lower than the upper end of the first NMOS lower spacer layer 170, and an upper end of the third NMOS lower spacer layer 370 may be lower than the upper end of second NMOS lower spacer layer 270. A width in the first horizontal direction X of the source/drain epitaxial layers (e.g., the first to third NMOS source/drain epitaxial layers 150, 250, and 350) corresponding to the first to third NMOS lower spacer layers 170, 270, and 370 may be wide, such that pitting pass may be less likely to occur, and even when an upper end of the lower spacer layer is formed at a low level, the function of a protective layer may be sufficiently performed.

A thickness in the vertical direction of the second NMOS lower spacer layer 270 may be smaller than a thickness in the vertical direction of the first NMOS lower spacer layer 170, and a thickness in the vertical direction of the third NMOS lower spacer layer 370 may be smaller than a thickness in the vertical direction of the second NMOS lower spacer layer 270. By adjusting the thickness in the vertical direction Z of each of the lower spacer layers (e.g., the first to third NMOS lower spacer layers 170, 270, and 370) to be inversely proportional to the width in the first horizontal direction X of each of the source/drain epitaxial layers (e.g., the first to third NMOS source/drain epitaxial layers 150, 250, and 350), process optimization and space utilization efficiency may be improved.

The thickness in the vertical direction of the second void V2 may be larger than the thickness in the vertical direction of the first void V1, and the thickness in the vertical direction of the third void V3 may be larger than the thickness in the vertical direction of the second void V2. Parasitic coupling suppression conditions required for each of the transistor regions (e.g., the first to third NMOS transistor regions N1, N2, and N3) may be efficiently implemented.

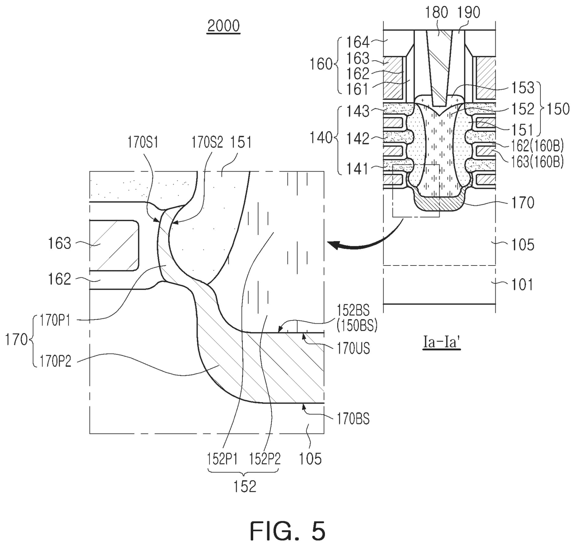

FIG. 5 is a cross-sectional diagram and an enlarged diagram illustrating a semiconductor device taken along line la-la' according to one or more embodiments.

Referring to FIG. 5, a semiconductor device 2000 in an example embodiment may be configured the same as or similar to the example described with reference to FIGS. 1 to 4B, other than the configuration in which the second portion 170P2 of the first NMOS lower spacer layer 170 may comprise a lower surface 170BS in contact with an upper surface of the first active region 105, and an upper surface 170US in contact with the lower surface 150BS of the first NMOS source/drain epitaxial layer 150.

Accordingly, the description of the semiconductor device 1000 illustrated in FIGS. 1 to 4B may be combined with the description of the semiconductor device 2000 according to the example embodiment, unless otherwise indicated.

In the semiconductor device 2000, the second epitaxial layer 152 may be (e.g., further) disposed to extend to the region in which the first void V1 was disposed.

The second portion 170P2 of the first NMOS lower spacer layer 170 may comprise a lower surface 170BS in contact with an upper surface of the first active region 105, and an upper surface 170US in contact with the lower surface of the first NMOS source/drain epitaxial layer 150. The second portion 170P2 of the first NMOS lower spacer layer 170 may comprise an upper surface 170US in contact with the lower surface 152BS of the second epitaxial layer 152.

The second epitaxial layer 152 may be disposed on the first NMOS lower spacer layer 170. The second portion 170P2 of the first NMOS lower spacer layer 170 may have a recessed 'U' shaped upper surface. The second epitaxial layer 152 may have the first region 152P1, and may have a second region 152P2, which is a region disposed below the first region 152P1 and surrounded by the first NMOS lower spacer layer 170. In one or more embodiments, at least a portion of the first region 152P1 may be surrounded by the first portion 170P1 of the first NMOS lower spacer layer 170, and the second region 152P2 may be surrounded by the second portion 170P2 of the first NMOS lower spacer layer 170.

The second region 152P2 may be disposed between the second portion 170P2 of the first NMOS lower spacer layer 170 and the first region 152P1. The second region 152P2 may comprise the same material as that of the first region 152P1.

The second region 152P2 may be disposed to be completely enclosed by the first region 152P1 and the first NMOS lower spacer layer 170. That is, the second region 152P2 may be in contact with an internal side surface of the first NMOS lower spacer layer 170 surrounding a side surface of the second region 152P2. The lower surface 152BS of the second epitaxial layer 152 may be the same as a lower surface of the second region 152P2. The lower surface 152BS of the second region 152P2 may be in contact with an upper surface 170US of the first NMOS lower spacer layer 170.

By disposing the first NMOS source/drain epitaxial layer 150 instead of the first void V1, a structural gap in the corresponding region may be eliminated, and mechanical continuity may be ensured, such that structural stability of the entire device may be improved. By replacing a space in which the first void V1 is disposed with the second epitaxial layer 152, the physical defect of the first NMOS source/drain epitaxial layer 150 may be prevented. The structural stability may have a positive effect on ensuring essential long-term reliability in a highly integrated circuit.

Also, since the second epitaxial layer 152 is formed instead of the first void V1, doping profile may be precisely implemented in the first NMOS source/drain epitaxial layer 150. Particularly, in the case of the third region (P3, see FIG. 2C) in which a dopant such as phosphorus (P) is injected at a high concentration, the epitaxial layer may be formed consecutively, such that a doping depth and a diffusion boundary may be clearly controlled. This characteristic may contribute to improving performance of an NMOS device requiring high-speed operation and low leakage current.

Although not illustrated, similarly to the second epitaxial layer 152, the fifth epitaxial layer 252 may be (e.g., further) disposed in the region in which the second void V2 is disposed. Although not illustrated, similarly to the second epitaxial layer 152, as for the eighth epitaxial layer 352, the eighth epitaxial layer 352 may be (e.g., further) disposed in the region in which the third void V3 was disposed.

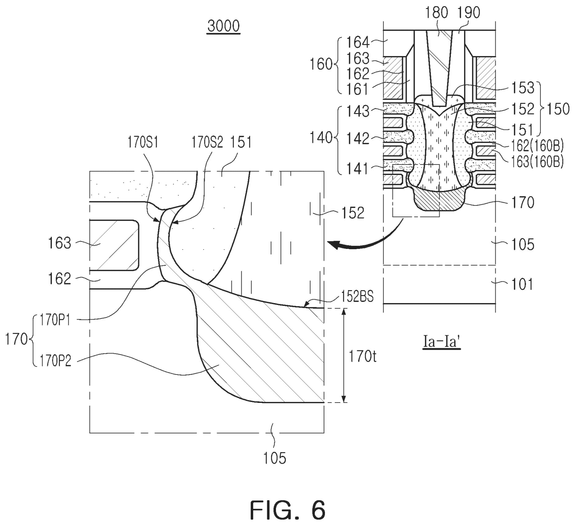

FIG. 6 is a cross-sectional diagram and an enlarged diagram illustrating a semiconductor device taken along line la-la' according to one or more embodiments.

Referring to FIG. 6, a semiconductor device 3000 in an example embodiment may be configured the same as or similar to the example described with reference to FIGS. 1 to 5, other than the configuration in which the second portion 170P2 of the first NMOS lower spacer layer 170 has a greater thickness in the vertical direction, and is thus in contact with the first NMOS source/drain epitaxial layer 150.

Accordingly, the description of the semiconductor devices 1000 and 2000 illustrated in FIGS. 1 to 5 may be combined with the description of the semiconductor device 3000 according to the example embodiment, unless otherwise indicated.

In the semiconductor device 3000, the second portion 170P2 of the first NMOS lower spacer layer 170 may be (e.g., further) disposed to extend to the region in which the first void V1 was disposed.

The first NMOS lower spacer layer 170 may be disposed below the first NMOS source/drain epitaxial layer 150. A level of an upper surface of the second portion 170P2 of the first NMOS lower spacer layer 170 may be substantially the same as a level of the lower surface of the first NMOS source/drain epitaxial layer 150.

A maximum thickness 170t in the vertical direction Z of the first NMOS lower spacer layer 170 may be a maximum thickness 170t in the vertical direction Z of the second portion 170P2 of the first NMOS lower spacer layer 170. The maximum thickness 170t in the vertical direction Z of the first NMOS lower spacer layer 170 may be greater than the maximum thickness 270t in the vertical direction Z of the second NMOS lower spacer layer 270 and the maximum thickness 370t in the vertical direction Z of the third NMOS lower spacer layer 370.

When the first NMOS lower spacer layer 170 is formed to have a great thickness in the vertical direction Z, the first NMOS lower spacer layer 170 may be effectively insulated with the first active region 105 and may also improve structural stability. The first NMOS lower spacer layer 170 having a great thickness may reduce electrical coupling between the first NMOS source/drain epitaxial layer 150 and the first active region 105, thereby suppressing leakage current.

Also, when the first NMOS lower spacer layer 170 has a sufficient thickness, the first NMOS lower spacer layer 170 may provide a buffering effect against thermal stress or mechanical load which may occur during a process, thereby improving structural reliability of the semiconductor device. The protection effect from impurity diffusion from the first NMOS source/drain epitaxial layer 150 to the first active region 105 may also be strengthened, such that long-term stability of device characteristics may be ensured.

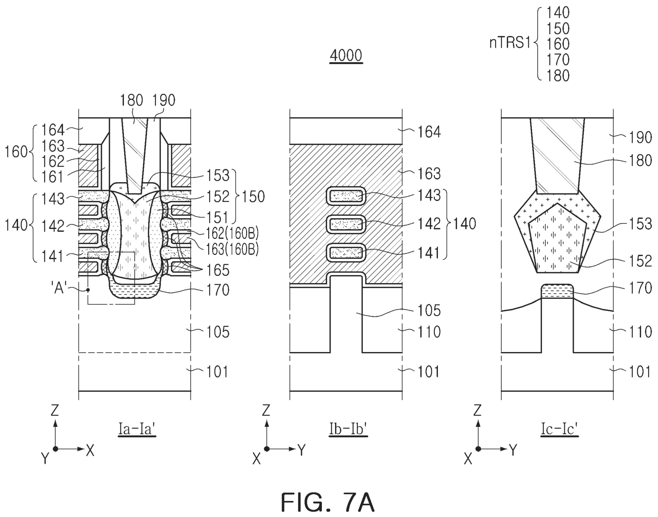

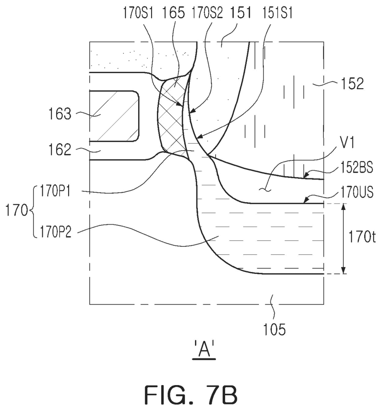

FIG. 7A is a cross-sectional diagram illustrating a semiconductor device taken along lines la-la', Ib-Ib', and Ic-Ic' according to one or more embodiments. FIG. 7B is an enlarged diagram illustrating region "A" illustrated in FIG. 7A.

Referring to FIGS. 7A and 7B, a semiconductor device 4000 in an example embodiment may be configured the same as or similar to the example described with reference to FIGS. 1 to 4B, other than the configuration in which an external side spacer 165 is further comprised on the external side of the gate electrode layer 163 of the lower portion 160B.

Accordingly, the description of the semiconductor device 1000 illustrated in FIGS. 1 to 4B may be combined with the description of the semiconductor device 4000 according to the example embodiment, unless otherwise indicated.

In the semiconductor device 4000, when an external side spacer 165 is further comprised on an external side of the gate electrode layer 163 of the lower portion 160B, the external side surface of the first epitaxial layer 151 may have a gently curved shape.

The semiconductor device 4000 may comprise the external side spacer 165. The external side spacers 165 may be disposed between the first NMOS source/drain epitaxial layers 150. The external side spacers 165 may vertically overlap the first NMOS channel layers 141, 142, and 143. As illustrated in FIG, 7A, the external side spacer 165 may be disposed between the first NMOS channel layers 141, 142, and 143 of the first NMOS channel structure 140, and between the first NMOS lower channel layer 141 of the first NMOS channel layers 141, 142, and 143 and the first active region 105.

The external side spacer 165 may comprise an insulating nitride. For example, the external side spacer 165 may comprise silicon nitride. The external side spacer 165 may be disposed between the first NMOS source/drain epitaxial layer 150 and the first NMOS gate dielectric layer 162 on both sides of the first NMOS source/drain epitaxial layer 150. The external side spacer 165 may be in contact with the first NMOS source/drain epitaxial layer 150, and specifically, the external side spacer 165 may be in contact with the first epitaxial layer 151.

In at least one of the external side spacers 165, a maximum thickness in the vertical direction Z of a portion vertically overlapping (e.g., vertically directly overlapping) the first NMOS gate dielectric layer 162 (e.g., in contact with the first NMOS gate dielectric layer 162) may be smaller than a maximum thickness in the vertical direction Z of a portion vertically overlapping (e.g., vertically directly overlapping) the first NMOS channel structure 140 (e.g., in contact with the first NMOS channel structure 140). For example, the external side spacer 165 may have a width (e.g., a thickness in the vertical direction Z) decreasing in the direction toward the first NMOS gate electrode layer 163 in the first horizontal direction X from the first NMOS source/drain epitaxial layer 150.

The external side spacer 165 may be in contact with the first portion 170P1 of the first NMOS lower spacer layer 170. The first portion 170P1 of the first NMOS lower spacer layer 170 may be disposed between the first epitaxial layer 151 and the external side spacer 165.

Although not illustrated, the semiconductor device 4000 may further comprise the second NMOS transistor structure (nTRS2, see FIG. 3A) and an external side spacer 165 on the external side of the gate electrode layer (263, see FIG. 3A) in a lower portion (260B, see FIG. 3A) of the second NMOS transistor structure nTRS2.

Although not illustrated, the semiconductor device 4000 may further comprise the third NMOS transistor structure (nTRS3, see FIG. 4A) and an external side spacer 165 on an external side of the gate electrode layer (363, see FIG. 4A) in the lower portion (360B, see FIG. 4a) of the third NMOS transistor structure nTRS3.

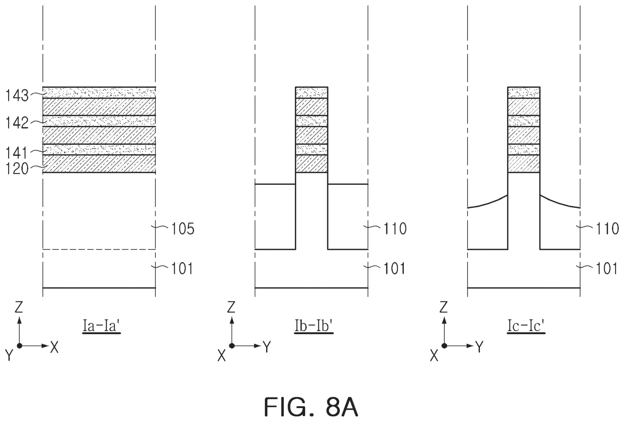

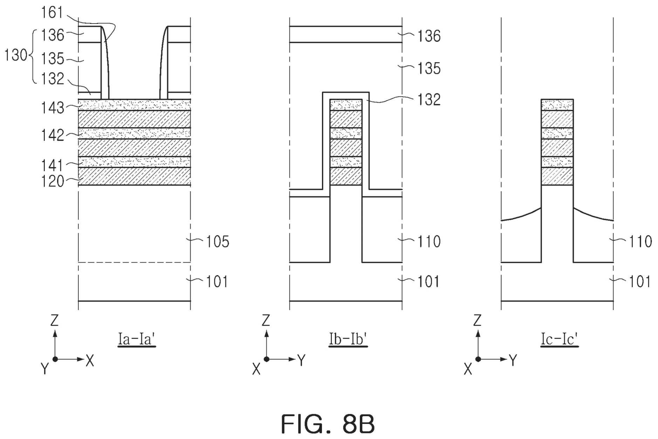

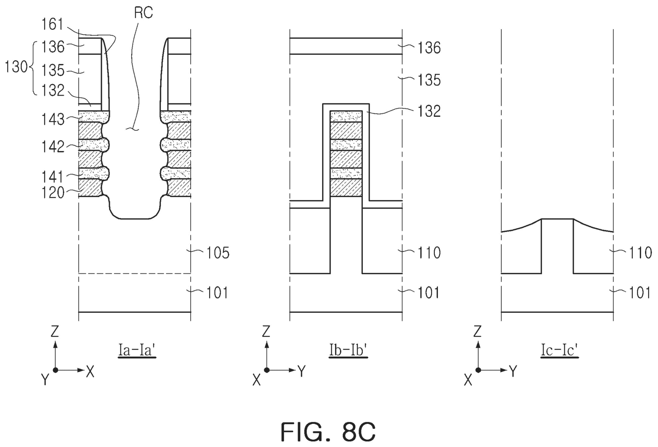

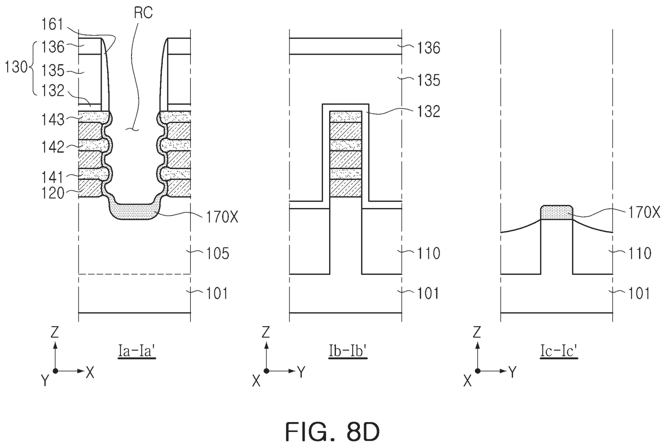

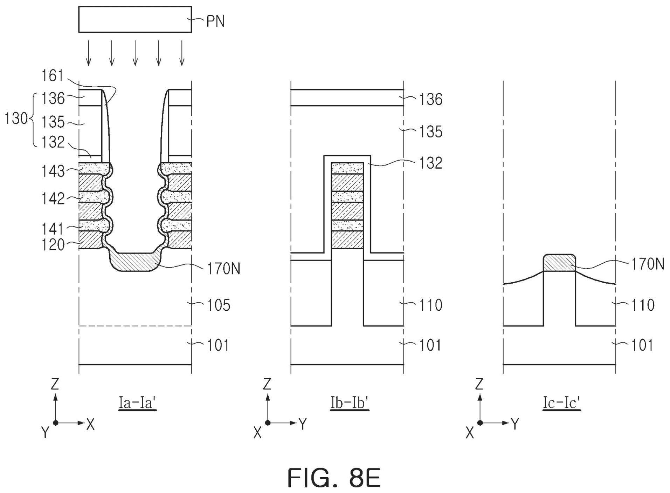

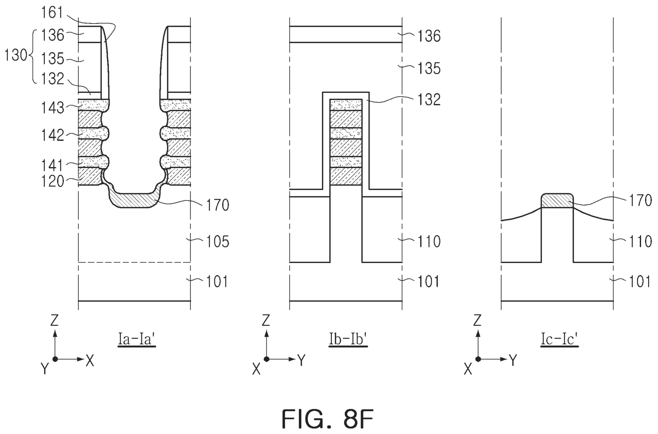

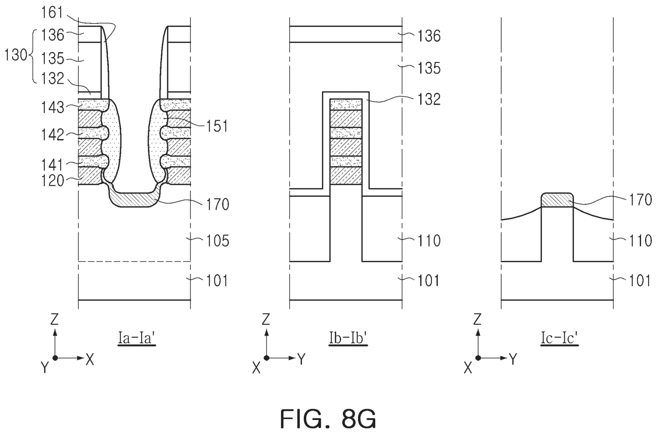

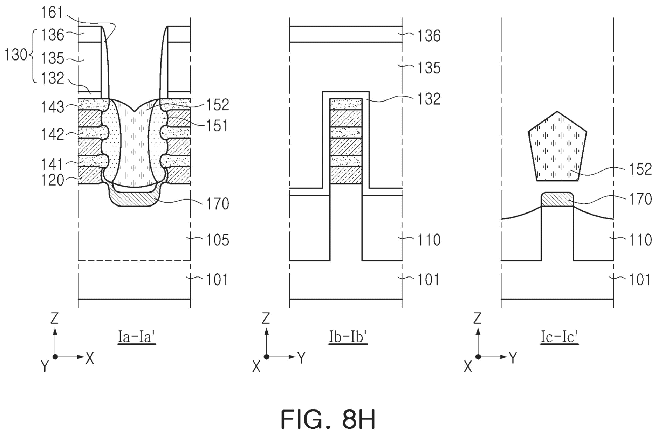

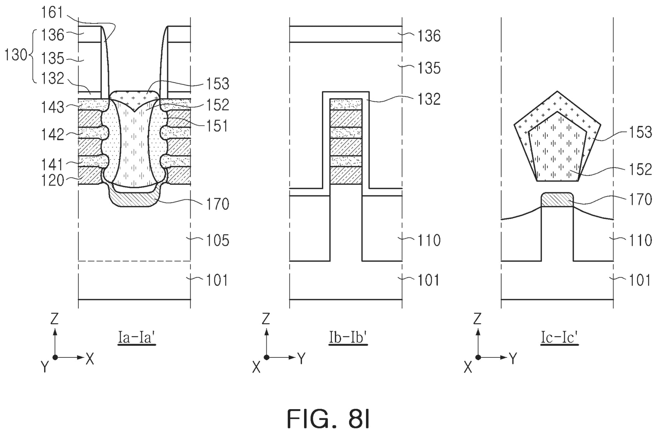

FIGS. 8A, 8B, 8C, 8D, 8E, 8F, 8G, 8H, 8I, and 8J are cross-sectional diagrams illustrating a method of manufacturing a semiconductor device according to one or more embodiments. FIGS. 8A, 8B, 8C, 8D, 8E, 8F, 8G, 8H, 8I, and 8J illustrate an example embodiment of a method of manufacturing the semiconductor device in FIGS. 1 to 4, and illustrate cross-sectional surfaces corresponding to FIG. 2A.

Referring to FIG. 8A, sacrificial layers 120 and the first NMOS channel layers 141, 142, and 143 may be alternately stacked on the substrate 101.

The sacrificial layers 120 may be replaced with the first NMOS gate dielectric layer 162 and the first NMOS gate electrode layer 163 as in FIG. 2A through a subsequent process. The sacrificial layers 120 may be formed of a material having etch selectivity with respect to the first NMOS channel layers 141, 142, and 143. The first NMOS channel layers 141, 142, and 143 may comprise a material different from that of the sacrificial layers 120. In an example embodiment, the first NMOS channel layers 141, 142, and 143 may comprise silicon (Si), and the sacrificial layers 120 may comprise silicon germanium (SiGe).

The sacrificial layers 120 and the first NMOS channel layers 141, 142, and 143 may be formed by performing an epitaxial growth process using the substrate 101 as a seed. Each of the sacrificial layers 120 and the first NMOS channel layers 141, 142, and 143 may have a thickness in the range of about 0.1 nm to 100 nm. The number of the first NMOS channel layers 141, 142, and 143 alternately stacked with the sacrificial layer 120 may be varied in one or more embodiments.

Thereafter, by removing the stack structure of the sacrificial layers 120 and a portion of the first NMOS channel layers 141, 142, and 143 and a portion of substrate 101, active structures may be formed.

The active structure may comprise sacrificial layers 120 and first NMOS channel layers 141, 142, and 143 alternately stacked, and may further comprise a first active region 105 formed by removing a portion of substrate 101 and protruding into an upper surface of substrate 101 (e.g., protruding from the upper surface of substrate 101). The active structures may be formed in a line shape extending in one direction, for example, the first horizontal direction X, and may be disposed spaced apart from each other in the second horizontal direction Y.

In the region from which a portion of the substrate 101 is removed, by filling an insulating material and recessing the insulating material such that the first active region 105 protrudes, device isolation layers 110 may be formed. An upper surface of the device isolation layers 110 may be formed at a level lower than a level of an upper surface of the first active region 105.

Referring to FIG. 8B, sacrificial gate structures 130 and first NMOS gate spacer layers 161 may be formed on the active structures.

The sacrificial gate structures 130 may be sacrificial structures formed in a region in which the first NMOS gate dielectric layer 162 and the first NMOS gate electrode layer 163 are disposed on the first NMOS channel structure 140 as illustrated in FIG. 2A through a subsequent process. The sacrificial gate structure 130 may comprise first and second sacrificial gate layers 132 and 135, and a mask pattern layer 136, stacked in order. The first and second sacrificial gate layers 132 and 135 may be patterned using the mask pattern layer 136. The first and second sacrificial gate layers 132 and 135 may be an insulating layer and a conductive layer, respectively. For example, the first sacrificial gate layer 132 may comprise silicon oxide, and the second sacrificial gate layer 135 may comprise polysilicon. The mask pattern layer 136 may comprise silicon nitride. The sacrificial gate structures 130 may have a line shape extending in one direction by intersecting the active structures. The sacrificial gate structures 130 may extend, for example, in the second horizontal direction Y and may be spaced apart from each other in the first horizontal direction X.

The first NMOS gate spacer layers 161 may be formed on both sides of the sacrificial gate structures 130. The first NMOS gate spacer layers 161 may be formed by forming a film of a uniform thickness along upper surfaces and side surfaces of the sacrificial gate structures 130 and the active structures, and anisotropically etching the film. The first NMOS gate spacer layers 161 may be formed of a low-κ material, and may comprise, for example, at least one of SiO, SiN, SiCN, SiOC, SiON, and SiOCN.

Referring to FIG. 8C, the first NMOS channel structures 140 may be formed by removing the exposed sacrificial layers 120 and the first NMOS channel layers 141, 142, and 143 between the sacrificial gate structures 130 and forming a recess RC.

The exposed sacrificial layers 120 and the first NMOS channel layers 141, 142, and 143 may be removed using the sacrificial gate structures 130 and the first NMOS gate spacer layers 161 as a mask. The remaining sacrificial layers 120 may have inwardly curved side surfaces inwardly by being removed from a side surface in the first horizontal direction X to a predetermined depth. The remaining first NMOS channel layers 141, 142, and 143 may have outwardly curved side surfaces on the external side as the side surface in the first horizontal direction X is etched. However, the shapes of the side surfaces of the sacrificial layers 120 and the first NMOS channel layers 141, 142, and 143 are not limited to the illustrated example. The side surfaces of the sacrificial layers 120 and the first NMOS channel layers 141, 142, and 143 may be coplanar in a vertical direction perpendicular to an upper surface of the substrate 101.

Referring to FIG. 8D, the oxide layer 170X may be formed on side surfaces of the first NMOS channel structure 140 and side surfaces of the sacrificial layers 120 exposed through the recess RC, and an upper surface of the first active region 105.

The oxide layer 170X may be formed on an upper surface of the first active region 105, the side surface of the first NMOS channel structure 140 exposed because the sacrificial gate structure 130 is not disposed, and the side surfaces of the sacrificial layer 120.

By depositing the oxide layer 170X on the substrate 101 in which the recess RC is formed, the oxide layer 170X may be formed along a sidewall and a bottom of the recess RC. For example, the deposition process may have anisotropic characteristics, such that a difference in thickness distribution may be exhibited depending on the deposition direction. Particularly, the oxide layer 170X may start to be formed relatively thinly on the upper sidewall of recess RC, and a thickness thereof may gradually increase downwardly along the sidewall. The oxide layer 170X having the greatest thickness may be formed in the bottom region of the recess RC. For example, when performing the deposition process, process conditions may be configured such that the main movement direction of particles used for deposition may be vertically downward. There may be a difference in the thickness of oxide layer 170X depending on a shape of the recess RC, but the oxide layer 170X may be continuously formed along an inner wall of the recess RC overall.

Referring to FIG. 8E, a nitride layer 170N may be formed on the oxide layer 170X formed in the recess RC using a nitriding device (or referred to as a nitridation treatment device) PN.

The oxide layer 170X may be formed on the substrate 101 having the recess RC, and the nitride layer 170N may be formed by performing a nitriding process on the surface of the oxide layer 170X. For example, by applying a nitrogen component to the surface of the oxide layer 170X through a plasma nitriding process using the nitriding device PN, interface nitriding may be performed without a thermal process. The plasma may be generated using N₂, NH₃ or N₂/H₂ mixed gas, and radicals or ions in the plasma may react with the oxide layer 170X to form the nitride layer 170N. The nitride layer 170N may be formed instead of the oxide layer 170X formed along the inner wall of the recess RC

The nitridation process through the nitridation treatment device PN may be performed in the plasma directional nitridation (PDN) manner. The PDN method may induce a reaction on the surface of an upper portion of the oxide layer 170X by accelerating nitrogen radicals or ions in the plasma in the vertical direction Z under an electric field. Accordingly, excessive nitride formation may be suppressed on the sidewall of the recess RC, and a nitride layer 170N may be formed in the center of an upper surface of the first active region 105.

Referring to FIG. 8F, by removing a portion of the nitride layer 170N formed on the side surface of the first NMOS channel structure 140 and an upper surface of the first active region 105, the first NMOS lower spacer layer 170 may be formed.

The first NMOS lower spacer layer 170 may be formed by selectively removing the nitride layer 170N. For example, by performing an isotropic dry etching process, the nitride layer 170N formed on the side surface and the bottom region of the recess RC may be partially removed, thereby forming the first NMOS lower spacer layer 170. In this case, in the etching process, a portion of the nitride layer 170N may be selectively removed using a plasma-based gas composition or a wet etching solution. A portion of the nitride layer 170N formed on an upper surface of the first active region 105 and the nitride layer 170N formed below the first NMOS lower channel layer 141 may remain and may form the first NMOS lower spacer layer 170. The nitride layer 170N may be removed from the side surfaces of the first NMOS intermediate channel layer 142 and the first NMOS upper channel layer 143, and the side surfaces of the first NMOS intermediate channel layer 142 and the first NMOS upper channel layer 143 may be exposed. In one or more embodiments, the first NMOS lower spacer layer 170 may be formed only on the lower edge or the lower surface of the recess RC.

Referring to FIG. 8G, the first epitaxial layer 151 may be formed in the recess RC.

The first epitaxial layer 151 may be formed in the recess RC to be in contact with the first NMOS channel layers 141, 142, and 143 and the sacrificial layers 120. The surface in which the first epitaxial layer 151 is in contact with the first NMOS channel layers 141, 142, and 143 and the sacrificial layers 120 may have a wavy shape. The first epitaxial layer 151 may be formed to cover the plurality of the first NMOS channel layers 141, 142, and 143 and the sacrificial layers 120, and may expose an upper surface of the first NMOS lower spacer layer 170.

The first epitaxial layer 151 may comprise silicon (Si) doped with a group 15 element. According to an example embodiment, the first epitaxial layer 151 may comprise one of phosphorus (P), arsenic (As), antimony (Sb), and bismuth (Bi). The first epitaxial layer 151 may be formed by supplying a silicon (Si) source gas under a carrier gas supply. The second and third epitaxial layers described below may also be formed in a similar manner.

The first epitaxial layer 151 may have etch selectivity lower than that of the sacrificial layers. Accordingly, in the process in FIG. 8J described below, the sacrificial layers 120 may be selectively removed, and the first NMOS source/drain epitaxial layer 150 protected by the first epitaxial layer 151 may remain.

Referring to FIG. 8H, the second epitaxial layer 152 may be formed on the first epitaxial layer 151.

The second epitaxial layer 152 may be conformally formed to have a substantially uniform thickness on both side surfaces of the first epitaxial layer 151. The second epitaxial layer 152 may be formed to cover the entire side surfaces of the first epitaxial layer 151, but an example embodiment thereof is not limited thereto.

The second epitaxial layer 152 may comprise silicon (Si) doped with a group 15 element. In one or more embodiments, the second epitaxial layer 152 may comprise one of phosphorus (P), arsenic (As), antimony (Sb), and bismuth (Bi). In one or more embodiments, the second epitaxial layer 152 may comprise phosphorus (P) at a concentration higher than that of the first epitaxial layer 151.

Referring to FIG. 8I, a third epitaxial layer 153 may be formed by epitaxy growing silicon (Si) on the second epitaxial layer 152.

The third epitaxial layer 153 may comprise silicon (Si) doped with a group 15 element. In one or more embodiments, the third epitaxial layer 153 may comprise one of phosphorus (P), arsenic (As), antimony (Sb), and bismuth (Bi). In one or more embodiments, the third epitaxial layer 153 may comprise phosphorus (P) at a concentration lower than that of the second epitaxial layer 152. In an example embodiment, the third epitaxial layer 153 may not substantially comprise phosphorus (P).

Referring to FIG. 8J, a first interlayer insulating layer 190 may be formed between adjacent sacrificial gate structures 130 on the third epitaxial layer 153, and the sacrificial layers 120 and the sacrificial gate structures 130 may be removed.

The first interlayer insulating layer 190 may be formed by forming an insulating film covering the sacrificial gate structures 130 and the first NMOS source/drain epitaxial layers 150 and performing a planarization process.

The sacrificial layers 120 and the sacrificial gate structures 130 may be selectively removed with respect to the first NMOS gate spacer layers 161, the first interlayer insulating layer 190, and the first NMOS channel layers 141, 142, and 143. First, the upper gap regions UR may be formed by removing the sacrificial gate structures 130, and the lower gap regions LR may be formed by removing the sacrificial layers 120 exposed through the upper gap regions UR. For example, when the sacrificial layers 120 comprise silicon germanium (SiGe) and the first NMOS channel layers 141, 142, and 143 comprise silicon (Si), the sacrificial layers 120 may be selectively removed by performing a wet etching process using peracetic acid as an etchant. During the removal process, the first NMOS source/drain epitaxial layers 150 may be protected by the first epitaxial layer 151 formed in an outermost region and having a low etch selectivity. During the removal process, the first NMOS source/drain epitaxial layers 150 may be protected by the first NMOS lower spacer layer 170 formed below the first NMOS source/drain epitaxial layers 150.

The first NMOS lower spacer layer 170 may effectively prevent a locally deep pitting pass in a portion of the first NMOS source/drain epitaxial layer 150 and the first active region 105 during the process of removing silicon germanium (SiGe) sacrificial layers 120 for the gate structure. In an example embodiment, the first NMOS lower spacer layer 170 may physically shield a lower portion of the first epitaxial layer 151 from damage of partial erosion of the adjacent SiP-based first epitaxial layer 151 when SiGe is removed, thereby preventing unnecessary etching and ensuring structural stability of the first NMOS source/drain epitaxial layer 150. Particularly, in the case in which precise maintenance of the facet of the source/drain region is required in a fine process, the structure may prevent damage to the epitaxial layer, thereby improving a process margin. The first NMOS lower spacer layer 170 may function as a protective layer of the source/drain region, rather than simply a structural boundary layer as described above.

Thereafter, referring to FIGS. 2A, 2B, and 2C together, the first NMOS gate structure 160 may be formed in the upper gap regions UR and the lower gap regions LR.

A first NMOS gate dielectric layer 162 may be formed to conformally cover internal surfaces of the upper gap regions UR and the lower gap regions LR. A first NMOS gate electrode layer 163 may be formed to completely bury the upper gap regions UR and the lower gap regions LR. The first NMOS gate electrode layer 163 and the first NMOS spacer layers 161 may be removed downwardly from the upper gap regions UR to a predetermined depth. A first NMOS gate capping layer 164 may be formed in the region from which the first NMOS gate electrode layer 163 and the first NMOS spacer layers 161 are removed from the upper gap regions UR. Accordingly, a first NMOS gate structure 160 including the first NMOS gate dielectric layer 162, the first NMOS gate electrode layer 163, the first NMOS spacer layers 161, and the first NMOS gate capping layer 164 may be formed.

Thereafter, a contact hole may be formed by patterning the first interlayer insulating layer 190, and a first NMOS contact plug 180 may be formed by filling a conductive material in the contact hole. A lower surface of the contact hole may be recessed into the source/drain epitaxial layer 150. In the example, the first NMOS contact plug 180 may be formed to penetrate a portion of the third epitaxial layer 153. The shape and the arrangement of the first NMOS contact plug 180 are not limited thereto and may be varied.

Although the process of forming the second NMOS transistor structure nTRS2 of the second NMOS transistor region N2 and the third NMOS transistor structure nTRS3 of the third NMOS transistor region N3, which are in FIGS. 1, 3A, and 4A, is not illustrated, the regions may also form a transistor structure including a lower spacer layer (270 and 370, see FIGS. 3A and 4A) through a process similar to the first NMOS transistor region.

The transistor structures (nTRS1, nTRS2, and nTRS3, see FIGS. 2A to 4B) in each of the regions (N1, N2, N3, see FIG. 1) may be formed independently through processes corresponding to FIGS. 8A, 8B, 8C, 8D, 8E, 8F, 8G, 8H, 8I, and 8J, and in this case, non-target regions may be physically shielded through a protective material to prevent process interference. For example, when forming the first NMOS transistor structure (nTRS1, see FIG. 2) in the first NMOS transistor region (N1, see FIG. 1), the second and third NMOS transistor regions (N2, N3, see FIG. 1) may be covered and protected by a protective material such as photoresist to be prevented from being affected by unnecessary etching or deposition.

Similarly, in the process of forming the second NMOS transistor structure (nTRS2, see FIG. 3A) in the second NMOS transistor region (N2, see FIG. 1), the first and third NMOS transistor regions (N1 and N3, see FIG. 1) may be protected, and also in the process of forming the third NMOS transistor structure (nTRS3, see FIG. 4A) in the third NMOS transistor region (N3, see FIG. 1), the first and second NMOS transistor regions (N1 and N2, see FIG. 1) may be protected.

Through this isolation process, the transistor structure in each region may be precisely implemented, and process interference between regions may be reduced. However, an example embodiment thereof is not limited thereto, and the processes may be performed simultaneously. Accordingly, in the example embodiment, the semiconductor devices illustrated in FIGS. 1 to 4B may be stably manufactured.

According to one or more embodiments of the present disclosure, a method of manufacturing a semiconductor device comprises forming an active structure, the active structure including sacrificial layers and channel layers alternately stacked on the active region in the vertical direction; forming a sacrificial gate structure on a first region of the active structure; forming a recess by etching the sacrificial layers and the channel layers on one side of the sacrificial gate structure; forming a lower spacer layer on a bottom surface of the recess; and forming a source/drain epitaxial layer disposed on the lower spacer layer and filling the recess.

Forming the lower spacer layer may comprise forming an oxide layer on side surfaces of the channel structure and side surfaces of the sacrificial layers exposed through the recess and an upper surface of the active region.

Forming the lower spacer layer or forming the oxide layer may further comprise forming a nitride layer on the oxide layer formed in the recess using a nitriding treatment device.

Forming the lower spacer layer or forming the nitride layer may further comprise removing the entirety of the nitride layer formed on the side surfaces of the channel structure and a portion of the nitride layer formed on the upper surface of the active region.

Forming the source/drain epitaxial layer may comprise forming a first epitaxial layer to be in contact with exposed side surfaces of the channel layers and the sacrificial layers.

Forming the source/drain epitaxial layer may further comprise forming a second epitaxial layer on both side surfaces of the first epitaxial layer.

The method may further comprise forming an interlayer insulating layer between the sacrificial gate structures adjacent to each other on the source/drain epitaxial layer, and removing the sacrificial layers and the sacrificial gate structure.

Removing the sacrificial layers and the sacrificial gate structure may comprise exposing a portion of the lower spacer layer during the removing process.

The first epitaxial layer may comprise a material different from a material of the sacrificial layer.

Removing a portion of the nitride layer may comprise partially exposing a side surface of the channel structure by removing the nitride layer from a side surface of the channel structure, and covering the upper surface of the active region with the nitride layer without being exposed.

According to the aforementioned one or more embodiments, transistor structures (e.g., MOS transistor structures having the same conductivity; e.g., first to third NMOS transistor structures including source/drain epitaxial layers having different widths and different lower spacer layers may be provided. Accordingly, transistor structures (e.g., MOS transistor structures; e.g., NMOS transistor structures) which may prevent or reduce pitting passes which may occur between the source/drain epitaxial layers (150) and the sacrificial layer when the sacrificial layer is removed for forming a gate electrode may be provided.

## Claims

1. A semiconductor device (1000), comprising:
an active region (105) extending in a first horizontal direction (X);
a plurality of channel layers (140) apart from each other in a vertical direction (Z) perpendicular to the first horizontal direction (X) on the active region (105);
a gate structure (160) intersecting the active region (105) and the plurality of channel layers (140) and on one or more of the plurality of channel layers (140);
a source/drain epitaxial layer (150) on the active region (105) and in contact with one or more of the plurality of channel layers (140); and
a lower spacer layer (170),
wherein the gate structure (160) comprises:
a gate electrode layer (163) on one or more of the plurality of channel layers (140) in a second horizontal direction (Y) perpendicular to the vertical direction (Z) and the first horizontal direction (X); and
a gate dielectric layer (162) between the gate electrode layer (163) and the plurality of channel layers (140), and between the gate electrode layer (163) and the source/drain epitaxial layer (150),
wherein the lower spacer layer (170) comprises:
a first portion (170P1) between the gate dielectric layer (162) and the source/drain epitaxial layer (150); and
a second portion (170P2) between the active region (105) and the source/drain epitaxial layer (150).

2. The semiconductor device (1000) of claim 1, further comprising:
a void (V1) between the second portion (170P2) of the lower spacer layer (170) and the source/drain epitaxial layer (150),
wherein at least a portion of a lower surface (152BS) of the source/drain epitaxial layer (150) is exposed by the void (V1).

3. The semiconductor device (1000) of claim 1 or 2,
wherein the source/drain epitaxial layer (150) comprises:
a first epitaxial layer (151) on one or more side surfaces of the plurality of channel layers (140) and a side surface of the gate structure (160); and
a second epitaxial layer (152) on the lower spacer layer (170), and
wherein the first epitaxial layer (151) is between the second epitaxial layer (152) and the one or more side surfaces of the plurality of channel layers (140), and between the second epitaxial layer (152) and the side surface of the gate structure (160).

4. The semiconductor device (1000) of claim 3,
wherein at least a portion of the first epitaxial layer (151) is in contact with the first portion (170P1) of the lower spacer layer (170).

5. The semiconductor device (1000) of claim 3 or 4,
wherein the second epitaxial layer (152) is spaced apart from the first portion (170P1) of the lower spacer layer (170).

6. The semiconductor device (1000) of any one of claims 3 to 5,
wherein the first portion (170P1) of the lower spacer layer (170) is in contact with a side surface of the first epitaxial layer (151).

7. The semiconductor device (1000) of any one of claims 3 to 6,
wherein the first portion (170P1) of the lower spacer layer (170) is in contact with a side surface of the gate dielectric layer (162).

8. The semiconductor device (1000) of any one of claims 3 to 7, wherein a concentration of phosphorus (P) in the first epitaxial layer (151) is lower than a concentration of phosphorus, P, in the second epitaxial layer (152).

9. The semiconductor device (1000) of any one of claims 3 to 8, wherein a concentration of phosphorus (P) in the second epitaxial layer (152) increases in a direction from the second epitaxial layer (152) toward the second portion (170P2) of the lower spacer layer (170).

10. The semiconductor device (1000) of any one of claims 1 to 9, wherein the second portion (170P2) of the lower spacer layer (170) comprises a lower surface (170S1) in contact with an upper surface of the active region (105), and an upper surface (170S2) in contact with a lower surface (152BS) of the source/drain epitaxial layer (150).

11. The semiconductor device (1000) of any one of claims 1 to 10, wherein the lower spacer layer (170) comprises an insulating nitride.

12. The semiconductor device (1000) of any one of claims 1 to 11,
wherein a portion of an upper surface of the second portion (170P2) of the lower spacer layer (170) is spaced apart from a portion of a lower surface of the source/drain epitaxial layer (150).

13. The semiconductor device (1000) of any one of claims 1 to 12,
wherein the plurality of channel layers (140) include a first lower channel layer (141) in a lowermost portion of the plurality of channel layers (140), and
wherein an upper end of the first portion (170P1) of the lower spacer layer (170) is at a substantially same level as a lower surface of the first lower channel layer (141).

14. The semiconductor device (1000) of any one of claims 1 to 12,
wherein the plurality of channel layers (140) include a first lower channel layer (141) in a lowermost portion of the plurality of channel layers (140), and
wherein an upper end of the first portion (170P1) of the lower spacer layer (170) is at a lower level than a level of a lower surface of the first lower channel layer (141).

15. The semiconductor device (1000) of any one of claims 1 to 12,
wherein the gate dielectric layer (162) is spaced apart from the lower spacer layer (170).
